(19) **Europäisches Patentamt / European Patent Office / Office européen des brevets**

(11) **EP 1 514 074 B1**

(12) **EUROPEAN PATENT SPECIFICATION**

(45) Date of publication and mention
of the grant of the patent:
**21.05.2014 Bulletin 2014/21**

(51) Int Cl.:
**G01B 9/02** (2006.01)    **G03F 7/20** (2006.01)

(21) Application number: **03760467.5**

(22) Date of filing: **17.06.2003**

(86) International application number:
**PCT/US2003/019340**

(87) International publication number:
**WO 2003/106919 (24.12.2003 Gazette 2003/52)**

(54) **INTERFEROMETRY SYSTEMS INVOLVING A DYNAMIC BEAM-STEERING ASSEMBLY**

INTERFEROMETRISCHES SYSTEM MIT EINER DYNAMISCHEN LICHTSTRAHLSTEUERVORRICHTUNG

SYSTEMES D'INTERFEROMETRIE UTILISANT UN ENSEMBLE D'ORIENTATION DE FAISCEAU DYNAMIQUE

(84) Designated Contracting States:
**NL**

(30) Priority: **17.06.2002  US 389527 P**

(43) Date of publication of application:
**16.03.2005  Bulletin 2005/11**

(73) Proprietor: **ZYGO CORPORATION Middlefield, CT 06455-0448 (US)**

(72) Inventors:
• **HILL, Henry Tucson, AZ 85716 (US)**

• **KREUZER, Justin Trumbull, CT 06611 (US)**

(74) Representative: **HOFFMANN EITLE Patent- und Rechtsanwälte Arabellastrasse 4 81925 München (DE)**

(56) References cited:
**EP-A- 0 388 594    US-A- 4 859 066 US-A- 5 757 160    US-B1- 6 313 918**

**Description**

Background of the Invention

Displacement measuring interferometers monitor changes in the position of a measurement object relative to a reference object based on an optical interference signal. The interferometer generates the optical interference signal by overlapping and interfering a measurement beam reflected from the measurement object with a reference beam reflected from the reference object.

In US 6,313,918 B1, there is described an interferometry system which includes at least one dynamic beam steering assembly for redirecting one or more beams within the interferometry system in response to changes in the angular orientation or position of the measurement object. A control circuit controls the beam steering assembly based on a signal derived from one or more beams within the interferometry system. The dynamic beam steering assembly can be incorporated into interferometry systems that measure displacement, angle, and/or dispersion. The interferometry systems can be advantageously incorporated into lithography systems used to fabricate integrated circuits and other semiconducting devices and beam writing systems used to fabricate lithography masks.

In many applications, the measurement and reference beams have orthogonal polarizations and different frequencies. The different frequencies can be produced, for example, by laser Zeeman splitting, by acousto-optical modulation, or internal to the laser using birefringent elements or the like. The orthogonal polarizations allow a polarizing beam splitter to direct the measurement and reference beams to the measurement and reference objects, respectively, and combine the reflected measurement and reference beams to form overlapping exit measurement and reference beams. The overlapping exit beams form an output beam that subsequently passes through a polarizer.

The polarizer mixes polarizations of the exit measurement and reference beams to form a mixed beam. Components of the exit measurement and reference beams in the mixed beam interfere with one another so that the intensity of the mixed beam varies with the relative phase of the exit measurement and reference beams. A detector measures the time-dependent intensity of the mixed beam and generates an electrical interference signal proportional to that intensity. Because the measurement and reference beams have different frequencies, the electrical interference signal includes a "heterodyne" signal having a beat frequency equal to the difference between the frequencies of the exit measurement and reference beams. If the lengths of the measurement and reference paths are changing relative to one another, *e.g.,* by translating a stage that includes the measurement object, the measured beat frequency includes a Doppler shift equal to $2\nu np/\lambda$, where $\nu$ is the relative speed of the measurement and reference objects, $\lambda$ is the wavelength of the measurement and reference beams, *n* is the refractive index of the medium through which the light beams travel, *e.g.,* air or vacuum, and *p* is the number of passes to the reference and measurement objects. Changes in the relative position of the measurement object correspond to changes in the phase of the measured interference signal, with a $2\pi$ phase change substantially equal to a distance change *L* of $\lambda/(np)$, where *L* is a round-trip distance change, e.g., the change in distance to and from a stage that includes the measurement object.

Unfortunately, this equality is not always exact. In addition, the amplitude of the measured interference signal may be variable. A variable amplitude may subsequently reduce the accuracy of measured phase changes. Many interferometers include non-linearities such as what are known as "cyclic errors." The cyclic errors can be expressed as contributions to the phase and/or the intensity of the measured interference signal and have a sinusoidal dependence on the change in optical path length *pnL*. In particular, the first harmonic cyclic error in phase has a sinusoidal dependence on $(2\pi pnL)/\lambda$ and the second harmonic cyclic error in phase has a sinusoidal dependence on $2(2\pi pnL)/\lambda$. Higher harmonic cyclic errors and subharmonic cyclic errors can also be present.

There are also "non-cyclic non-linearities" such as those caused by a change in lateral displacement (*i.e.,* "beam shear") between the reference and measurement beam components of an output beam of an interferometer when the wavefronts of the reference and measurement beam components have wavefront errors. This can be explained as follows.

Inhomogeneities in the interferometer optics may cause wavefront errors in the reference and measurement beams. When the reference and measurement beams propagate collinearly with one another through such inhomogeneities, the resulting wavefront errors are identical and their contributions to the interferometric signal cancel each other out. More typically, however, the reference and measurement beam components of the output beam are laterally displaced from one another, i.e., they have a relative beam shear. Such beam shear causes the wavefront errors to contribute an error to the interferometric signal derived from the output beam.

Moreover, in many interferometry systems beam shear changes as the position or angular orientation of the measurement object changes. For example, a change in relative beam shear can be introduced by a change in the angular orientation of a plane mirror measurement object. Accordingly, a change in the angular orientation of the measurement object produces a corresponding error in the interferometric signal.

The effect of the beam shear and wavefront errors will depend upon procedures used to mix components of the output beam with respect to component polarization states and to detect the mixed output beam to generate an electrical interference signal. The mixed output beam may for example be detected by a detector without any focusing of the mixed beam onto the detector, by detecting the mixed output beam as a beam focused onto a detector, or by launching the mixed output beam into a single mode or multi-mode optical fiber and detecting a portion of the mixed output beam that is transmitted by the optical fiber. The effect of the beam shear and wavefront errors will also depend on properties of a beam stop should a beam stop be used in the procedure to detect the mixed output beam. Generally, the errors in the interferometric signal are compounded when an optical fiber is used to transmit the mixed output beam to the detector.

Amplitude variability of the measured interference signal can be the net result of a number of mechanisms. One mechanism is a relative beam shear of the reference and measurement components of the output beam that is for example a consequence of a change in orientation of the measurement object.

In dispersion measuring applications, optical path length measurements are made at multiple wavelengths, *e.g.,* 532 nm and 1064 nm, and are used to measure dispersion of a gas in the measurement path of the distance measuring interferometer. The dispersion measurement can be used in converting the optical path length measured by a distance measuring interferometer into a physical length. Such a conversion can be important since changes in the measured optical path length can be caused by gas turbulence and/or by a change in the average density of the gas in the measurement arm even though the physical distance to the measurement object is unchanged.

The interferometers described above are often crucial components of scanner systems and stepper systems used in lithography to produce integrated circuits on semiconductor wafers. Such lithography systems typically include a translatable stage to support and fix the wafer, focusing optics used to direct a radiation beam onto the wafer, a scanner or stepper system for translating the stage relative to the exposure beam, and one or more interferometers. Each interferometer directs a measurement beam to, and receives a reflected measurement beam from, a plane mirror attached to the stage. Each interferometer interferes its reflected measurement beams with a corresponding reference beam, and collectively the interferometers accurately measure changes in the position of the stage relative to the radiation beam. The interferometers enable the lithography system to precisely control which regions of the wafer are exposed to the radiation beam.

In many lithography systems and other applications, the measurement object includes one or more plane mirrors to reflect the measurement beam from each interferometer. Small changes in the angular orientation of the measurement object, *e.g.,* pitch and yaw of a stage, can alter the direction of each measurement beam reflected from the plane mirrors. If left uncompensated, the altered measurement beams reduce the overlap of the exit measurement and reference beams in each corresponding interferometer. Furthermore, these exit measurement and reference beams will not be propagating parallel to one another nor will their wave fronts be aligned when forming the mixed beam. As a result, the interference between the exit measurement and reference beams will vary across the transverse profile of the mixed beam, thereby corrupting the interference information encoded in the optical intensity measured by the detector.

To address this problem, many conventional interferometers include a retroreflector that redirects the measurement beam back to the plane mirror so that the measurement beam "double passes" the path between the interferometer and the measurement object. The presence of the retroreflector insures that the direction of the exit measurement is insensitive to changes in the angular orientation of the measurement object. When implemented in a plane mirror interferometer, the configuration results in what is commonly referred to as a high-stability plane mirror interferometer (HSPMI). However, even with the retroreflector, the lateral position of the exit measurement beam remains sensitive to changes in the angular orientation of the measurement object. Furthermore, the path of the measurement beam through optics within the interferometer also remains sensitive to changes in the angular orientation of the measurement object.

In practice, the interferometry systems are used to measure the position of the wafer stage along multiple measurement axes. For example, defining a Cartesian coordinate system in which the wafer stage lies in the x-y plane, measurements are typically made of the x and y positions of the stage as well as the angular orientation of the stage with respect to the z axis, as the wafer stage is translated along the x-y plane. Furthermore, it may be desirable to also monitor tilts of the wafer stage out of the x-y plane. For example, accurate characterization of such tilts may be necessary to calculate Abbe offset errors in the x and y positions. Thus, depending on the desired application, there may be up to five degrees of freedom to be measured. Moreover, in some applications, it is desirable to also monitor the position of the stage with respect to the z-axis, resulting in a sixth degree of freedom.

To measure each degree of freedom, an interferometer is used to monitor distance changes along a corresponding metrology axis. For example, in systems that measure the x and y positions of the stage as well as the angular orientation of the stage with respect to the x, y, and z axes, at least three spatially separated measurement beams reflect from one side of the wafer stage and at least two spatially separated measurement beams reflect from another side of the wafer stage. See, e.g., U.S. Patent No. 5,801,832 entitled "Method of and Device for Repetitively Imaging a Mask Pattern on a Substrate Using Five Measuring Axes." Each measurement beam is recombined with a reference beam to monitor optical path length changes along the corresponding metrology axes. Because the different measurement beams contact the wafer stage at different locations, the angular orientation of the wafer stage can then be derived from appropriate combinations of the optical path length measurements. Accordingly, for each degree of freedom to be monitored, the system includes at least one measurement beam that contacts the wafer stage. Furthermore, as described above, each measurement beam may double-pass the wafer stage to prevent changes in the angular orientation of the wafer stage from corrupting the interferometric signal. The measurement beams may generated from physically separate interferometers or from multi-axes interferometers that generate multiple measurement beams.

Summary of the Invention

In view of the above, an object of the present invention is to provide an interferometry system which includes at least one dynamic beam steering assembly for redirecting one or more beams within the interferometry system in response to changes in the angular orientation or position of the measurement object.

In general, the invention features an apparatus according to claim 1.

The dynamic beam steering assembly can be incorporated into interferometry systems that measure distances, angle, and/or dispersion. It may positioned within an interferometer to direct one or both of a measurement beam and reference beam after they have been separated from an input beam, or it may positioned to direct an input beam (or portions thereof) into one or more interferometers. The dynamic beam steering assembly improves the performance of the interferometry system by reducing negative consequences of changes in the angular orientation or position of the measurement object.

The multi-axis interferometry system combines the two beams with one another after they contact the measurement object to produce an output beam including interferometric information about the changes in the angular orientation of the measurement object.

Preferably, during operation the control circuit calculates a control signal using the interferometric information in the output beam and causes the positioning system to orient the beam steering element based on the control signal. Furthermore, the control circuit includes a detector for measuring an intensity of the output beam, a signal processor for calculating the changes in the angular orientation of the measurement object from the measured intensity and generating the control signal from the calculated changes in angular orientation, and a control system for causing the positioning system to orient the beam steering element in response to the control signal. Also, the apparatus includes a polarizer prior to the detector to cause the measured intensity of the output beam to correspond to the intensity of a selected polarization component of the output beam.

Preferably, the multi-axis interferometry system directs at least three measurement beams to contact the measurement object at different locations.

Preferably, the changes in the angular orientation of the measurement object monitored by the interferometry system may be relative to a reference object. For example, the reference object may be fixed in the interferometry system.

In another aspect, the invention features a lithography system according to claim 11 for use in fabricating integrated circuits on a wafer, the system including: a stage for supporting the wafer; and an illumination system including a radiation source, a mask, a positioning system, a lens assembly, and either interferometry apparatus according to claim 1 described above, wherein during operation the source directs radiation through the mask to produce spatially patterned radiation, the positioning system adjusts the position of the mask relative to the radiation from the source, the lens assembly images the spatially patterned radiation onto the wafer, and the apparatus monitors the position of the mask relative to the radiation from the source. For example, the measurement object may include the mask, or the multi-axis interferometry system may be attached to the mask.

In another aspect, the invention features a beam writing system according to claim 14 for use in fabricating a lithography mask, the system including: a source providing a write beam to pattern a substrate; a stage supporting the substrate; a beam directing assembly for delivering the write beam to the substrate; a positioning system for positioning the stage and beam directing assembly relative one another; and either interferometry apparatus according to claim 1 described above for monitoring the position of the stage relative to the beam directing assembly.

In another aspect, the invention features a method for fabricating integrated circuits including using any of the lithography systems described above, according to claim 15 or 16..

Unless otherwise defined, all technical and scientific terms used herein have the same meaning as commonly understood by one of ordinary skill in the to which this invention belongs. In case of conflict with publications, patent applications, patents, and other references mentioned herein, the present specification, including definitions, will control. Other features, aspects, and advantages will be apparent from the following detailed description and from the claims.

Brief Description of the Drawings

Figs. 1 to 13 are cancelled.
FIG. **14a-c** relate to lithography and its application to manufacturing integrated circuits. FIG. **14a** is a schematic drawing of a lithography exposure system employing the interferometry system. FIGS. **14b** and **14c** are flow charts describing steps in manufacturing integrated circuits.

FIGS. **15a-15d** are schematic drawings of additional examples of interferometry systems.

FIG. **16** is a schematic of a beam writing system employing an interferometry system.

FIGS. **17a-17c** are schematic drawings of an angle and distance-measuring examples of interferometry systems. FIGS. **17a** and **17c** are cross-sectional views in perpendicular planes, and FIG. **17b** is a plan view looking into a plane perpendicular to that of FIG. **17a.**

Fig. 18 is cancelled.

FIGS. **19a-19c** relate to a dispersion-measuring realization of the interferometry system. FIG. **19a** is schematic drawing of the optical arrangement for the realization, FIG. **19b** is a schematic drawing of a signal processor used in the realization, and FIG. **19c** is a variation of the interferometer unit used in the optical arrangement.

Fig. 20 is cancelled.

FIG. 21 is a schematic drawing of an embodiment of the interferometry system according to the present invention, for providing interferometric angle information about the orientation of a measurement object and a beam steering assembly for directing an input beam into the interferometry system based on the interferometric angle information.


Detailed Description


The invention features an interferometry system including an interferometer and at least one beam steering assembly controlled by a control circuit. The beam steering assembly is separate from the interferometer, directing an input beam to the interferometer. The beam steering assembly redirects one or more of the input, output, reference, and measurement beams to minimize undesired consequences of changes in the angular orientation or position of the measurement object.

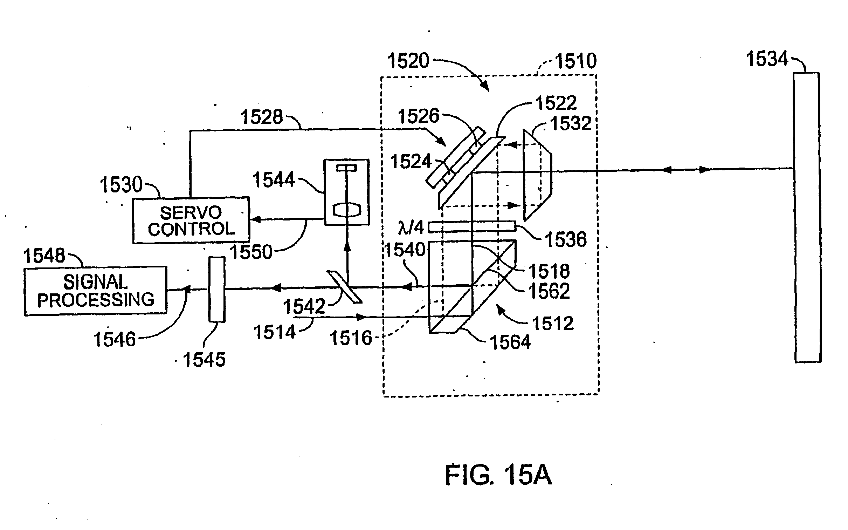

A schematic drawing of an interferometry system explained for an understanding of the present invention is shown in FIG. **15a.** A polarizing beam splitter **1512** in an interferometer **1510** receives an input beam **1514** from a laser source (not shown) and separates input beam **1514** into reference beam **1516** (dotted line) and measurement beam **1518** (solid line), which are linearly polarized orthogonal to one another. The polarizing beam splitter **1512** includes a polarizing interface **1562** for reflecting beams having a polarization orthogonal to the plane of FIG. **15a** and a back reflective surface **1564** for reflecting beams transmitted through polarizing interface **1562.**

In the described example, the orthogonally polarized reference and measurement beams are frequency-shifted with respect one another, *e.g.,* by Zeeman splitting, acousto-optic modulation, or by use of birefringent elements internal to the laser, prior to entering interferometer **1510** as components of input beam **1514.** The different frequencies enable the interferometry system to generate a heterodyne interference signal. Although the described example is a heterodyne system, it is readily adapted for use in a homodyne system in which the reference and measurement beams have the same frequencies.

Polarizing beam splitter **1512** directs the measurement beam **1518** to a beam steering assembly **1520,** which includes a beam steering mirror **1522** and a pair of piezoelectric transducers **1524** and **1526.** The transducers are coupled to the beam steering mirror **1522** by flexures to orient the beam steering mirror in response to a signal **1528** from a servo controller **1530.** The beam steering assembly may include capacitance gauges to measure changes in orientation and/or position of the beam steering mirror **1522.** The capacitance gauges may also be used to measure and/or monitor the properties of the piezoelectric transducers **1524** and **1526.**

Beam steering assembly **1520** directs the measurement beam through reference retroreflector **1532**, reference retroreflector **1532** being truncated so that a beam passing centrally through retroreflector **1532** is not retroreflected, to contact a stage mirror **1534,** *i.e.,* the measurement object, at substantially normal incidence. Stage mirror **1534** then reflects the measurement beam back to retrace its path to beam steering assembly 1520 and polarizing beam splitter **1512.** The measurement beam double passes a quarter wave plate **1536,** which is positioned between the beam steering assembly **1520** and polarizing beam splitter **1512** and which rotates the linear polarization of the measurement beam by 90°.

Polarizing beam splitter **1512** directs the reference beam **1516** to the beam steering assembly **1520,** which in turn directs the reference beam to reference retroreflector **1532.** The reference retroreflector then directs the reference beam back to beam steering assembly **1520** and onto polarizing beam splitter **1512.** The reference beam also double passes quarter wave plate **1536,** which rotates the linear polarization of the reference beam by 90°.

Polarizing beam splitter **1512** then recombines the polarization-rotated reference and measurement beams to form overlapping exit reference and measurement beams, which together form an output beam **1540.** A beam splitter **1542** sends a portion of output beam **1540** to a detector system **1544,** which measures the difference in directions of propagation of the exit reference and measurement beams. The detector system sends an error signal **1550** indicative of any such difference to servo controller **1530,** which sends signal **1528** to beam steering assembly **1520** in response to the error signal. The beam steering assembly **1520** changes, in response to signal **1528,** the orientation of beam steering mirror **1522** preferably about a nodal point of reference retroreflector **1532,** changes in orientation of beam steering mirror **1522** about a nodal point of reference retroreflector **1532** producing substantially reduced lateral shear effects experienced by the reference beam.

Alternatively when the direction of the input beam **1514** is constant, detector system **1544** can measure the difference in position of the exit measurement beam from a reference position in the detector system and generate error signal **1550** indicative of that difference in position, a difference in position of the exit measurement beam being the consequence of a change in direction of propagation of the exit measurement beam component of output beam **1540.** For example, the reference position can be the position of the exit measurement beam in the detector system corresponding to the measurement beam retroreflecting from stage mirror **1534,** *i.e.,* contacting the stage mirror at normal incidence, and the stage mirror **1534** being at a nominal null orientation. In other embodiments, the detector system can include multiple detectors for determining the direction and position of the exit reference and measurement beams and can generate an error signal based on such information.

Changes in the angular orientation of stage mirror **1534** change the direction of the measurement beam and the direction of subsequent exit measurement beam. This causes detector system **1544** to generate error signal **1550.** Servo-controller **1530** responds to the error signal by directing beam steering assembly **1520** to reorient beam steering mirror **1522** so as to minimize the error signal, *e.g.*, by directing the measurement beam to the stage mirror at normal incidence. As a result, the exit reference and measurement beams remain substantially parallel to one another and the position of the exit measurement beam remains substantially constant over a range of angular orientations of the stage mirror. Furthermore, since beam steering assembly **1520** redirects each of the reference and measurement beams twice, there is no change in the relative optical path length between the reference and measurement beams to first order in a translation of beam steering mirror **1522** in a direction normal to the reflecting surface of beam steering mirror **1522.** In addition, when the measurement beam is directed to the stage mirror at normal incidence and the paths of the measurement and reference beams have substantially the same centroids, there is no change in the relative optical path length between the reference and measurement beams to first order in any angular orientation change of the stage mirror (about the center of a measurement beam spot on the stage mirror) and any corresponding change in the beam steering element.

The remainder of output beam **1540,** after beam splitter **1542** passes through a polarizer **1545,** which mixes polarizations of the exit reference and measurement beams to form a mixed beam **1546.** A signal processing system **1548** measures the intensity of the mixed beam, *e.g.*, by photoelectric detection, to produce an electrical interference signal or electrical heterodyne signal, extracts the phase of the electrical heterodyne signal, and determines from that phase the difference in optical path length between the paths of the reference and measurement beams.

In other examples, detector system **1544** could be part of a separate angle sensing system (not shown), comprised of an additional light beam (not shown) directed towards stage mirror **1534.** The separate angle sensing system would measure the absolute or relative angular orientation of stage mirror **1534** using the additional light beam and would send a measurement signal to servo-controller **1530** indicative of that orientation. As in the example of FIG. **15a,** servo-controller **1530** would control beam steering assembly **1520** based on the signal from the detector system. In addition, in examples in which several interferometry systems each direct a measurement beam to a measurement object, a single angle sensing system can be used to guide control of the beam steering assembly in each of the interferometry systems.

Furthermore, in an interferometry systems (e.g., a multi-axis interferometry system) configured to measure the angular orientation of measurement stage, the angle measurement itself could be used to provide the error signal used to orient the beam steering element.

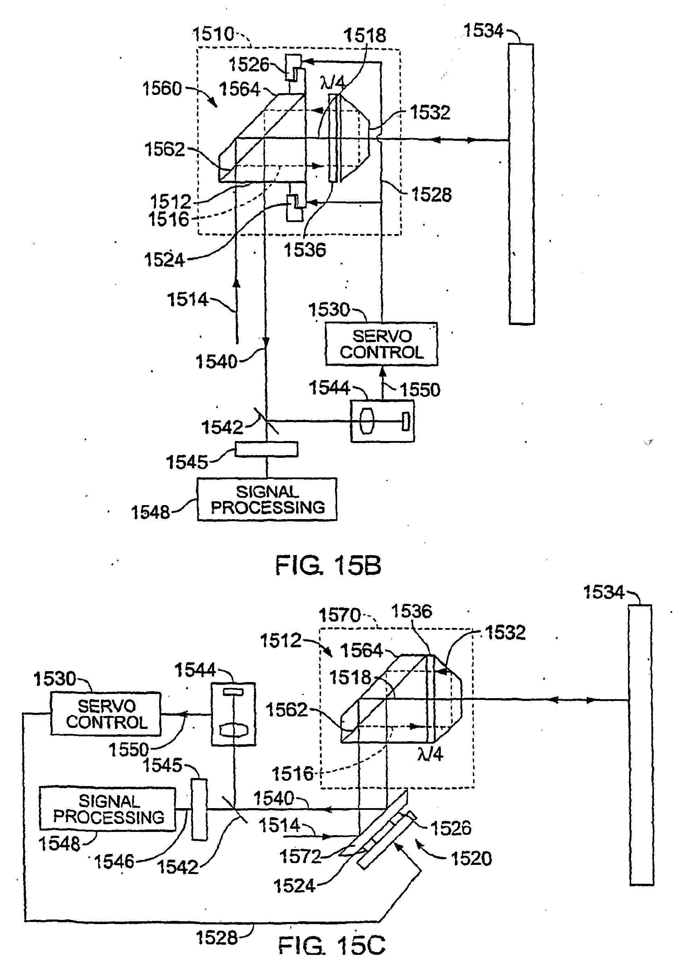

In another example similar to that of FIG. **15a,** a polarizing beam splitter **1512** and the beam steering assembly **1520** are combined into a single unit, as shown by polarizing beam splitter and beam steering assembly **1560** in FIG. **15b.** In this variation, transducers **1524** and **1526** are coupled through flexures directly to polarizing beam splitter **1512.** As a result, servo controller **1530** orients the polarizing interface **1562** and reflective back surface **1564** of polarizing beam splitter **1512** via transducers **1524** and **1526** to direct the reference and measurement beams to reference retroreflector **1532** and stage mirror **1534,** respectively. Quarter wave plate **1536** is positioned between reference retroreflector **1532** and beam steering assembly **1560.** Other features of this example are the same as those of the example in FIG. **15a** and are numbered the same.

In a further, similar to that of FIG. **15a** and shown in FIG. **15c,** input beam **1514** first contacts beam steering assembly **1520,** which then directs the input beam into the interferometer **1570.** In this example, the interferometer includes polarizing beam splitter **1512,** quarter wave plate **1536,** and reference retroreflector **1532,** but does not include beam steering assembly **1520,** which is outside the interferometer. As in the example of FIG. **15b,** the polarizing beam splitter **1512** directs the reference and measurement beams to reference retroreflector **1532** and stage mirror **1534,** respectively, and recombines the reflected reference and measurement beams to form the overlapping exit reference and measurement beams, which are the components of output beam **1540.** Beam steering assembly **1520** then receives output beam **1540** and directs it to detection system **1544** and signal processing system **1548,** as in the embodiment of FIG. **15a.**

As in the example of FIG. **15a,** servo controller **1530** in FIG. **15c** orients beam steering mirror **1522** of assembly **1520** to minimize the error signal generated by detection system **1544.** To do so, servo controller **1530** orients beam steering mirror **1522** of assembly **1520** to direct the input beam into interferometer **1570** such that the measurement beam contacts stage mirror **1534** at normal incidence over a range of angular orientations of the stage mirror. The beam steering assembly **1520** changes, in response to signal **1528,** the orientation of beam steering mirror **1522** preferably about a nodal point of reference retroreflector **1532,** changes in orientation of beam steering mirror **1522** about a nodal point of reference retroreflector **1532** producing substantially reduced lateral shear effects (tranverse displacement) on the reference beam. As a result, the exit reference and measurement beams, which form the output beam, emerge from the interferometer substantially parallel and with reduced transverse separation. Changes in the direction of the output beam emerging from the interferometer caused by the beam steering assembly redirecting the input beam are compensated when the output beam contacts the beam steering assembly, which directs the output beam to detection system **1544** and signal processing system **1548.** Although this compensation of the output beam direction by the beam steering assembly is preferable, it is not necessary because changes in the angular orientation of the stage mirror are typically small enough so as to not prevent the output beam from reaching the detection system **1544** and signal processing system **1548.** Thus in additional examples, the output beam need not contact the beam steering element.

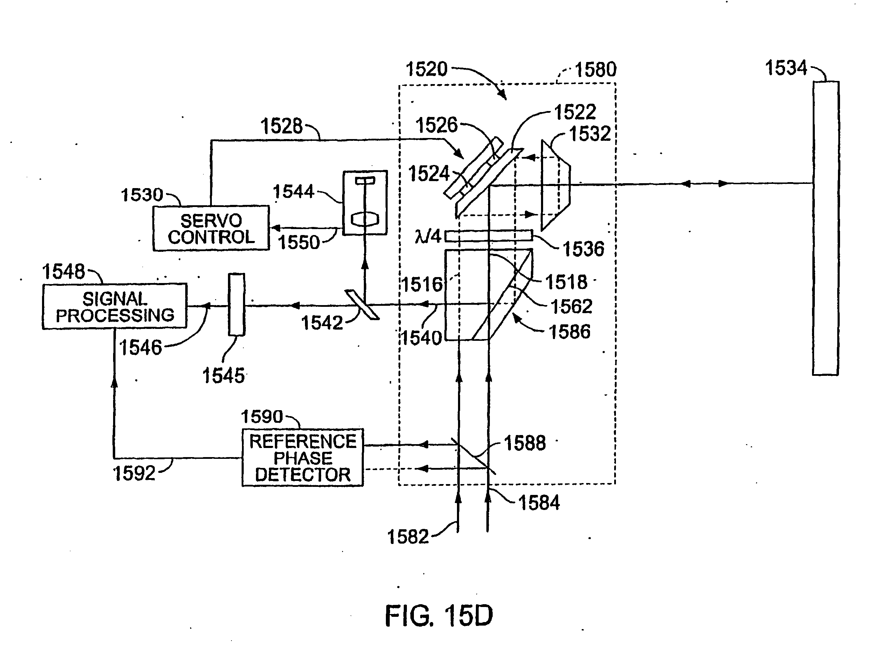

In another example similar to FIG. **15a** and shown in FIG. **15d,** the interferometry system receives a pair of spatially separated input beams to define the reference and measurement beams rather than separating a single input beam into the reference and measurement beams. In this example, an interferometer **1580** receives spatially separated input beams **1582** and **1584** polarized orthogonal to one another and a polarizing beam splitter **1586** directs the received input beams along different paths to define reference beam **1516** and measurement beam **1518.** Prior to entering polarizing beam splitter **1586,** a portion of the input beams is split off by a non-polarizing beam splitter **1588** and directed to a reference phase detector **1590.** The reference phase detector includes optics to optically mix the input beams and electronics to measure the relative optical phase of the mixed beams. Reference phase detector **1590** sends a reference phase signal **1592** indicative of the relative phase difference between input beams **1582** and **1584** upon entering interferometer **1580** to signal processing system **1548,** which uses signal **1592** to determine the difference in optical path length between the paths of the reference and measurement beams.

The remaining description for the example of FIG. **15d** is identical to that for FIG. **15a** with polarizing beam splitter **1586** recombining reference beam **1516** and measurement beam **1518** to form output beam **1540.** The example of FIG. **15d** and other such examples in which the interferometer receives spatially separated input beams to define the reference and measurement beams reduces paths within optics of the interferometer in which the reference and measurement beams overlap one another. Such a reduction reduces polarization mixing between the reference and measurement beams that can cause cyclic errors in the heterodyne signal measured by system **1548.** For a reference describing such cyclic errors, see, *e.g.,* N. Bobroff, Appl. Opt., 26:2676-2681, 1986. Also, in other examples such as that of FIG. **15c** in which the beam steering assembly is outside the interferometer, the beam steering mirror can direct spatially separated input beams into the interferometer to define the reference and measurement beams.

The concepts inherent in the systems described above and shown in FIGS. **15a-15d** can be extended to other applications. For example, other examples can address changes in the angular orientation and position of the measurement object along multiple dimensions. Also, other examples can insure that the transverse spatial profile of the exit reference beam is not inverted relative to that of the exit measurement beam when these beams are mixed to produce the interference signal. Also, other examples can include additional beam steering assemblies.

In general, these examples relate to apparatus and methods for measuring and monitoring a linear displacement of an object substantially independent of the orientation of the object and substantially independent of a lateral displacement of the object, wherein the lateral displacement is orthogonal to the linear displacement. An example of an important application is in using an interferometry system to measure and monitor along a given dimension the location of one or more stages in a lithographic tool that is stepping and/or scanning in either one, two, or three orthogonal dimensions.

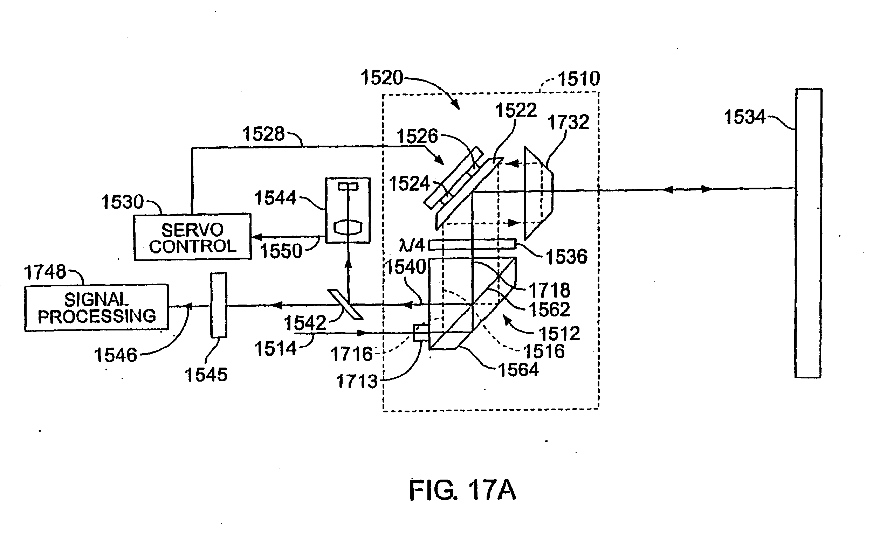

Interferometry systems having one or more beam steering assemblies can also be used to measure the angular orientation of a measurement object, in addition to measuring changes in displacement to the measurement object. To measure angular orientation of, e.g., a stage mirror, the interferometry system includes multiple displacement measuring interferometers that are "stacked" to measure distance to multiple, spatially separated locations on the stage mirror, from which the angular orientation of the stage mirror can be determined. For example, the distance from a reference plane to each of three non-collinear points on the stage mirror completely defines the position and angular orientation of the stage mirror. The interferometry system can include a beam steering assembly that directs beam(s) into and/or out of the stacked set of interferometers. Alternatively, the interferometry system can include a common beam steering assembly that directs at least one of the measurement and reference beams for each of the stacked set of interferometers. FIGS. **17a-c** illustrates such examples for two stacked interferometers. In either case, the angle information obtained by the interferometry system can be used to provide a control loop for orienting the beam steering element in the beam steering assembly.

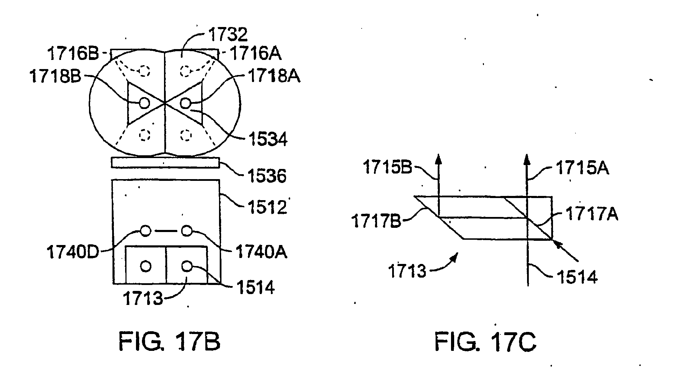

The interferometer **1710** of FIGS. **17a-c** is similar to that of FIG. **15a** described above except that retroreflector **1532** is replaced with a composite retroreflector **1732** (as illustrated in FIG. **17b**) and that the system further includes a splitting rhomb **1713** (as illustrated in FIG. **17c**) connected to polarizing beam splitter **1512**. As shown in FIG. **17c,** splitting rhomb **1713** receives input beam **1514** and separates it into two intermediate beams **1715a** and **1715b**. Splitting rhomb **1713** contains a non-polarizing beam splitting surface **1717a** to split the input beam **1514** and a reflective surface **1717b** to redirect intermediate beam **1715b** parallel to intermediate beam **1715a**. FIG. **17c** is in a plane perpendicular to that of FIG. **17a** and containing input beam **1514.**

Polarizing beam splitter **1512** separates intermediate beams **1715a** and **1715b** into reference beams **1716a** and **1716b** (dotted line) and measurement beams **1718a** and **1718b** (solid line), which are linearly polarized orthogonal to one another. FIG. **17a** illustrates only one set of reference and measurement beams with the other set propagating parallel to the first set in a second plane parallel to that of FIG. **17a.** Subsequent description of the reference and measurement beams will refer to both sets simultaneously as beams **1716** and **1718** unless otherwise specified.

Polarizing beam splitter **1512** directs the measurement beams **1718** to beam steering assembly **1520,** which directs the measurement beams through composite reference retroreflector **1732**. The composite reference retroreflector is truncated so that beams passing centrally through it are not retroreflected. As a result, beam steering assembly **1520** directs measurement beams **1718** to contact a stage mirror **1534,** *i.e.,* the measurement object, at substantially normal incidence. Stage mirror **1534** then reflects the measurement beams back to retrace their paths to beam steering assembly **1520** and polarizing beam splitter **1512**. The measurement beams double passes a quarter wave plate **1536,** which is positioned between the beam steering assembly **1520** and polarizing beam splitter **1512** and which rotates their linear polarizations by 90°.

Polarizing beam splitter **1512** directs the reference beams **1716** to beam steering assembly **1520,** which in turn directs the reference beams to composite reference retroreflector **1732**. The composite reference retroreflector then directs the reference beams back to beam steering assembly **1520** and onto polarizing beam splitter **1512**. The reference beams also double passes quarter wave plate **1536,** which rotates their linear polarizations by 90°. Polarizing beam splitter **1512** then recombines polarization-rotated reference and measurement beams **1716a** and **1718a** to form output beam **1740a,** which includes overlapping exit reference and measurement beams, and recombines polarization-rotated reference and measurement beams **1716b** and **1718b** to form output beam **1740b,** which includes overlapping exit reference and measurement beams.

FIG. **17b** is a view of the system looking towards a plane perpendicular to the plane of FIG. **17a** and containing the surface of stage mirror **1534**. FIG. **17b** shows transverse profiles of input beam **1514** on rhomb **1713,** reference beams **1716a** and **1716b** on composite reference retroreflector **1732,** measurement beams **1718a** and **1718b** on stage mirror **1534,** and output beams **1740a** and **1740b** exiting from polarizing beam splitter **1512.**

Beam splitter **1542** sends a portion of output beam **1740a** to detector system **1544,** which measures the difference in directions of propagation of the exit reference and measurement beams of the output beam. The detector system sends an error signal **1550** indicative of any such difference to servo controller **1530,** which sends signal **1528** to beam steering assembly **1520** to reorient the beam steering assembly in response to the error signal, as described previously.

Output beam **1740b** and the remainder of output beam **1740a** each pass through a polarizer that mixes the polarizations of their exit reference and measurement beam components. Signal processing system **1748** receives the mixed beams and determines changes in optical path length between reference beam **1716a** and measurement beam **1718a** and between reference beam **1716b** and measurement beam **1718b,** as described above. Based on the changes in measured optical path length and the separation between measurement beams **1718a** and **1718b** on stage mirror **1534,** signal processing system **1748** also determines changes in the angular orientation of the stage mirror.

In other examples, the angle information determined by signal processing system **1748** can be used to produce error signal **1550** for servo controller **1530** rather than detector system **1544.** In such examples, therefore, beam splitter **1542** and detector system **1544** are not required.

Moreover, in further examples, the beam steering assembly can be outside the interferometer. One such example includes an interferometry system identical to that of FIG. **15b,** except that like the example of FIG. **17a,** a splitting rhomb (e.g., splitting rhomb **1713**) is attached to polarizing beam splitter **1512** to split input beam **1514** into two parallel propagating beams, and retroreflector **1532** is replaced with composite retroreflector **1732**. Because of the splitting rhomb and the composite retroreflector, the interferometer produces two exit beams, just as the example of FIG. **17a** produces exit beams **1540a** and **1540b**. The treatment of the exit beams is identical to that of the example of FIG. **17a** in which a signal processor such as signal processor **1748** calculates angle based on signals derived from the two exit beams. Once again, in further examples, the angle information determined by signal processing system **1748** can be used to produce error signal **1550** for servo controller **1530** rather than detector system **1544.** In such examples, therefore, beam splitter **1542** and detector system **1544** are not required.

In the following, an embodiment of an interferometry system will be described that provides information about the angular orientation of the measurement object. It includes an angle-measuring interferometer that directs two beams to contact different locations of the measurement object and combines those beams after they contact measurement object to provide an output beam that directly includes interferometric information about the angular orientation of the measurement object. Such information is used to generate the control signal to the dynamic beam steering element, which is positioned to redirect one or both of the beams in the angle-measuring interferometer, another measurement beam in the interferometer (e.g., if the angle-measuring interferometer is part of multi-axis interferometer), or an input beam into the interferometer, wherein the beams that contact the measurement object are derived from the input beam.

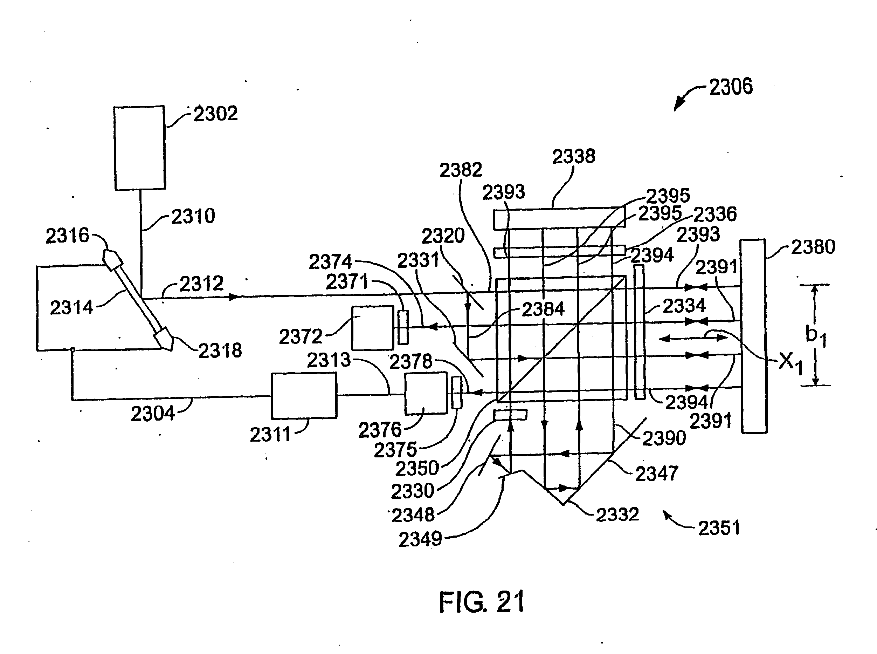

Such an embodiment is shown in FIG. 21. Source 2302 provides an input beam 2310, which includes orthogonally polarized components having a heterodyne frequency splitting as described previously. Input beam 2310 is incident on, and is redirected as input beam 2312 by, a dynamic beam steering assembly, which includes beam steering mirror 2314 and transducers 2316 and 2318 for dynamically orienting mirror 2314 in response to a control signal 2304 from a controller 2311. As described in previous examples, controller 2311 generates control signal 2304 to orient beam steering mirror 2314 in response to changes in the angular orientation of a measurement object 2380. In the embodiment, controller 2311 generates the control signal based on intensity information 2313 measured by a detector 2376 of an angle-measuring output beam 2378 produced by an interferometry system 2306.

Still referring to FIG. 21, interferometry system 2306 functions as follows. A non-polarizing beamsplitter 2320 splits input beam 2312 into an angle-measuring input beam 2382 and a distance-measuring input beam 2384. The distance-measuring portion of the interferometry system involves a high-stability plane mirror interferometer (HSPMI). The angle-measuring portion of the interferometry system directs angle-measuring beams to make single-passes to different points on the measurement object to produce an angle-measuring output beam based on optical differencing. As will be described in further detail below, the angle-measuring portion of the interferometry system shares a number of components with the distance-measuring HSPMI portion to produce an integrated system providing multiple measurement axes.

Referring still to FIG. 21, non-polarizing beamsplitter 2320 reflects distance-measuring input beam 2384 (via mirror 2331) to polarizing beamsplitter 2350, which splits it into two distance-measuring beams: a reflected reference beam 2395 and a transmitted measurement beam 2391. Reference beam 2395 then reflects from reference mirror 2338 and is then transmitted by polarizing beam splitter 2350 to retroreflector 2332 following a double pass through quarter wave plate 2336. Retroreflector 2332 then directs reference beam 2395 back to polarizing beamsplitter 2350, which transmits it back to reference mirror 2338, which in turn reflects it back to the polarizing beamsplitter after another double pass through quarter-wave plate 2336. Because of the double pass through the quarter-wave plate, polarizing beam splitter 2350 now reflects the reference beam as a reference beam component of a distance-measuring output beam 2374. Measurement beam 2391 reflects from measurement mirror 2380 and is then reflected by polarizing beam splitter 2350 to retroreflector 2332 following a double pass through quarter wave plate 2334. Retroreflector 2332 then directs measurement beam 2391 back to polarizing beamsplitter 2350, which reflects it back to measurement mirror 2380, which in turn reflects it back to the polarizing beamsplitter after another double pass through quarter-wave plate 2334. Because of the double pass through the quarter-wave plate, polarizing beam splitter 2350 now transmits the measurement beam as a measurement beam component of a distance-measuring output beam 2374.

Thus, following the double pass of measurement beam 2391 to measurement object 2380 and the double pass of reference beam 2395 to reference object 2338, polarizing beamsplitter 2350 recombines measurement and reference beams 2391 and 2395, respectively, to form distance-measuring output beam 2374. A polarizer 2371 mixes the polarization components of the distance-measuring output beam before it impinges on detector 2372. The phase of the distance-measuring output beam is derived from the measurement by detector 2372 and used to determine linear displacements of the plane mirror object along a measurement axis $X_1$.

Non-polarizing beamsplitter 2320 transmits angle-measuring input beam 2382 to polarizing beamsplitter 2350, which separates angle-measuring input beam 2382 into angle-measuring beams 2393 and 2394. Polarizing beamsplitter 2350 transmits angle-measuring beam 2393, which is then reflected by plane mirror measurement object 2380. After double passing quarter-wave plate 2334, angle-measuring beam 2393 returns to polarizing beamsplitter 2350, which reflects it as a first component of an intermediate beam 2390. Polarizing beamsplitter 2350 reflects beam 2394, which is then reflected by plane mirror reference object 2338. After double passing quarter-wave plate 2336, angle-measuring beam 2394 returns to polarizing beamsplitter 2350, which transmits it as a second component of an intermediate beam 2390.

Intermediate beam 2390 then makes three respective reflections from mirrors 2347, 2348, and 2349, which direct the intermediate beam back to polarizing beamsplitter 2350, which in turn separates the intermediate beam back into beams 2393 and 2394. Before reaching polarizing beamsplitter 2350, however, intermediate beam 2390 passes through half-wave retardation plate 2330, which rotates the linear polarizations of the components of the intermediate beam by 90 degrees. Because of the polarization rotation, polarizing beamsplitter 2350 subsequently reflects angle-measuring beam 2394 to plane mirror measurement object 2380 and transmits angle-measuring beam 2393 to plane mirror reference object 2338. Following reflections of beams 2394 and 2393 from the measurement and reference objects 2380 and 2338, respectively, and double-passes through quarter-wave plates 2334 and 2336, respectively, polarizing beamsplitter **2350** recombines the angle-measuring beams as components of angle-measuring output beam **2378.** Accordingly, beams **2393** and **2394** are recombined to form angle-measuring output beam **2378** after they each contact the plane mirror measurement object a single time at different points. A polarizer **2375** mixes the polarization components of angle-measuring output beam **2378** before it impinges on detector **2376.**

Components including retroreflector **2332,** mirrors **2347, 2348,** and **2349,** and half-wave retardation plate **2330** collectively define a return beam optical assembly **2351** that returns distance-measuring beams **2391** and **2395** back to polarizing beam-splitter **2350** between their first and second passes to the measurement and reference objects, respectively, and returns angle-measuring beams **2393** and **2394** back to polarizing beam-splitter **2350** after their pass to the measurement and reference objects, respectively, and before their pass to the reference and measurement objects, respectively.

Because each angle-measuring beam contacts the measurement object once, any angular deviation introduced by a tilt in measurement object **2380** will effect both components, and hence the beam components remain parallel at the output of the angular displacement interferometer. Furthermore, the angle-measuring output beam includes a relative phase shift $\varphi_1$ that is related to an angular change of the measurement object, $\theta_1$ (relative to the propagation direction of input beam **2312),** according to the formula $\varphi_1 = 2k_1 n_1 b_1 \theta_1$ where $b_1$ is the spacing between beams **2393** and **2394** at the plane mirror measurement object, wavenumber $k_1 = 2\pi/\lambda_1$ for wavelength $\lambda_1$ of the input beam **2310,** and $n_1$ is the index of refraction of a gas in the beam paths.

The return mirror system fold system including the three mirrors, **2347, 2348,** and **2349** for redirecting angle measuring beams **2393** and **2394** (when they are components of intermediate beam **2390)** back to polarizing beam splitter **2350** ensures that both components in angle-measuring output beam **2378** are parallel.

One advantage of the angle-measuring portion of interferometry system **2306** is that the differential beam shear of the components of the angle-measuring output beam at a detector or fiber-optic pickup (FOP) is substantially reduced compared for example to the differential beam shear in the output beam at the detector or FOP of the HSPMI. This is because both components of the angle-measuring output beams (i.e., angle-measuring beams **2393** and **2394)** undergo substantially equal amounts of shear upon a non-normal reflection from the measurement plane mirror and subsequent propagation back to the interferometer.

In yet further embodiments, interferometry system **2306** can be replaced with other interferometry system that include angle-measuring interferometers, such as those disclosed in commonly owned application U.S. Patent Application Serial No. 10/351,708 entitled "Multi-Axis Interferometer" by Henry A. Hill and filed January 27, 2003. Also in further embodiments, the dynamic beam steering element may be positioned to direct one of the beams within the angle measuring interferometer (e.g., one or both of the beams that contact the measurement object).

In any of the interferometry systems described above, the input, reference, measurements, intermediate, and output beams can include multiple, well-separated wavelengths to measure dispersion along the measurement path to the measurement object. The well-separated wavelengths can come from, for example, fundamental and frequency-doubled wavelengths of a laser, e.g., fundamental and doubled Nd:Yag at 1064 and 532 nm or doubled and quadrupled Nd:Yag at 532 and 266 nm. One such source is a Helium-Neon laser light source as described in U.S. Patent Application No 09/305,808 entitled "Helium-Neon Laser Light Source Generating Two Harmonically Related, Single-Frequency Wavelengths for Use in Displacement and Dispersion Measuring Interferometry" by William A. Shull and Carl A. Zanoni filed April 28, 1999. The measurement of changes in optical path length to the measurement object at multiple wavelengths can be used to correct the displacement measurement for air turbulence along the measurement path and covert the optical path length change to a geometric path length change.

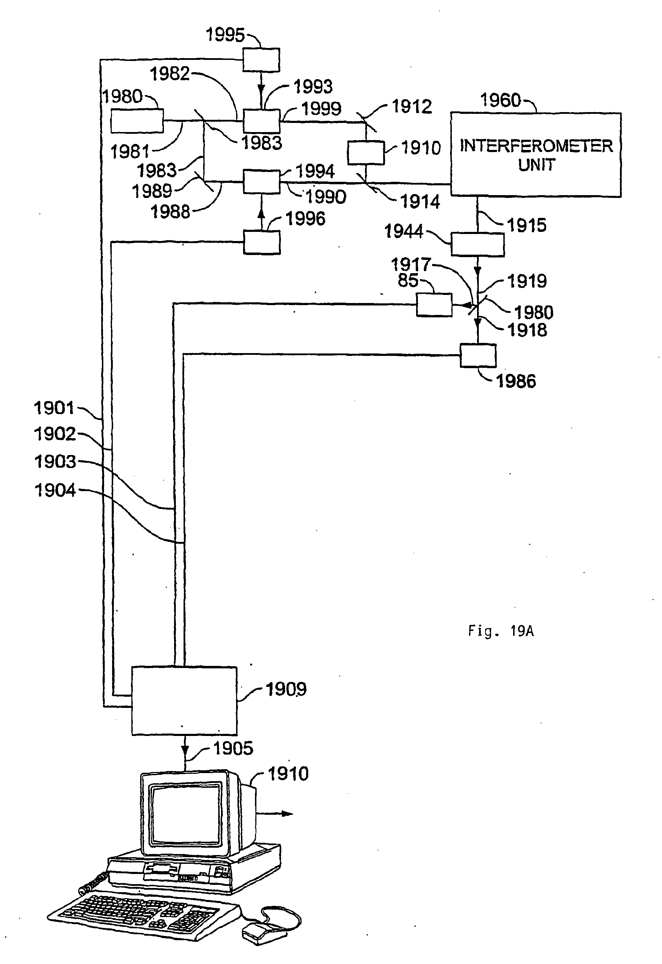

FIGS. 19a-b schematically illustrate a displacement and dispersion interferometry system as background to the present invention. A laser light source 1980 generates a light beam **1981** that is a coextensive superposition of two beams having well-separated, single-frequency wavelengths $\lambda_1$ and $\lambda_2$. The ratio of the wavelengths $(\lambda_1/\lambda_2)$ has a known value that can be expressed, at least approximately, as $l_1/l_2$ where $l_1$ and $l_2$ are integers. In some embodiments, the two-wavelengths are harmonically related. A dichroic beam splitter **1983** splits superposed beam **1981** into two single-wavelength beams **1982** and **1988,** beam **1982** at wavelength $\lambda_1$ and beam **1988** at $\lambda_2$. Beam **1982** passes through a first acousto-optical modulation system **1993** powered by driver **1995** to become beam **1999.** Similarly, beam **1988,** after being redirected by mirror **1989,** passes through a second acousto-optical modulation system **1994** powered by driver **1996** to become beam **1990.** Acousto-optical modulation systems **1993** and **1994** each produce a frequency splitting between orthogonal linear polarization components of beams **1999** and **1990,** respectively.

In particular, acousto-optical modulation system **1993** shifts the optical frequency of the x-polarization component of beam **1982** by an amount $f_1$ with respect to its y-polarization component to produce beam **1999.** Similarly, acousto-optical modulation system **1994** shifts the optical frequency of the x-polarization component of beam **1988** by an amount $f_2$ with respect to its y-polarization component to produce beam **1990.** In this description, the z-axis is collinear with the propagation direction of the beam, the x-axis is in the plane of FIG. **19a** perpendicular to the z-axis, and the y-axis is perpendicular to the plane of FIG. **19a.** The values of the frequency shifts $f_1$ and $f_2$ are determined by drivers **1995** and **1996,** respectively, and are many orders of magnitudes smaller (e.g., about $10^{-7}$ smaller) than the optical

frequencies defined by $\lambda_1$ and $\lambda_2$. Acousto-optical modulation systems **1993** and **1994** each include at least one acousto-optical modulator and one or more additional optical elements such as a prism and a birefringent element. Suitable acousto-optical modulation systems are described by G.E. Sommargren in U.S. Patent Nos. 4,684, 828 and 4,687,958, and by H.A. Hill in U.S. Patent Application No. 09/061,928 filed 4/17/98. The frequency splittings produced by the acousto-optical modulation systems permit the use of heterodyne interferometry techniques. Other frequency splitting techniques known in the art can also be used to produce heterodyne frequency splittings. Alternatively, homodyne interferometry techniques can be used in which case the frequency splittings are not necessary.

Either or both of acousto-optical modulation systems **1993** and **1994** can additionally introduce a frequency offset to both polarization components of beams **1982** and **1988,** respectively. For example, acousto-optical modulation system **1993** can shift the x-polarization component of beam **1982** by $f_0$ and its y-polarization component by $f_0 + f_1$, and acousto-optical modulation system **1994** can shift the x-polarization component of beam **1988** by $f_0$' and its y-polarization component by $f_0$' $+ f_2$. The frequency offsets can improve isolation between source **1980** and the interferometer downstream.

Beam **1999** is directed by mirror **1912** to dichroic beam splitter **1914,** which combines beams **1999** and beam **1990** into beam **1920**. Beam **1920** thus comprises frequency-shifted orthogonal polarization components at $\lambda_1$ and frequency-shifted orthogonal polarization components at $\lambda_2$, all of which are substantially coextensive and collinear. Beam-shaping optics **1910** modify the transverse spatial profile of beam **1999** so that the components of beam **1920** at $\lambda_1$ have similar diameters and, more particularly, similar transverse intensity profiles as those of the components of beam **1920** at $\lambda_2$. Beam-shaping optics **1910** can be positioned either before or after the acousto-optical modulation systems and can vary the beam at $\lambda_1$ or the beam at $\lambda_2$ where ever they are separated from one another. Suitable beam-shaping optics include, for example, beam expanders, beam compressors, variable density filters, and apodizing masks. Such elements can be used separately or in combination to produce the similar transverse intensity profiles.

Beam **1920** is directed into an interferometer unit **1960** that includes an interferometer and a beam steering assembly, as described in any of the embodiments above. Interferometer unit **1960** produces exit beam **1915** comprising an overlapping pair of exit reference and measurement beams at each of two wavelengths $\lambda_1$ and $\lambda_2$. As described above, the dynamic control system in interferometry unit **1960** reduces the consequences of changes in angular orientation or position of the measurement object on exit beam **1915**. The separate reference and measurement paths in interferometry unit **1960** a phase shift $\varphi_1$ between the x-polarized and y-polarized components of exit beam **1915** at wavelength $\lambda_1$ and introduces a phase shift $\varphi_2$ between the x-polarized and y-polarized components of exit beam **1915** at wavelength $\lambda_2$. An expression for the phase shifts is given by:

$$\varphi_j = Lpk_j n_j + \zeta_j \ , \quad \text{where } j = 1 \text{ or } 2, \tag{3}$$

where $L$ is the round trip distance traversed by measurement beam **1918,** $p$ is the number of round-trip passes in the interferometer ($p = 1$ for the presently described interferometer), $n_j$ is the average refractive index of gas **1998** at wavenumber $k_j = (2\pi)/\lambda_j$, and $\zeta_j$ is a phase-offset for wavelength $\lambda_j$, which includes all contributions to the phase shifts $\varphi_j$ that are not related to the path traversed by measurement beam **1918**. Because the components of measurement beam **1918** at wavelengths $\lambda_1$ and $\lambda_2$ traverse the same geometric distance $L$ but experience different refractive indices $n_1$ and $n_2$, the phases $\varphi_j$ can be used to determine dispersion in along the measurement path to the measurement object.

Polarizer **1944** (oriented, e.g., at 45 degrees to the plane of the FIG. **19a)** mixes the x- and y-polarization components of exit beam **1915** at each of wavelengths $\lambda_1$ and $\lambda_2$ to produce a mixed beam **1919.** A dichroic beam splitter **1980** then separates mixed beam **1919** into a first signal beam **1917** at wavelength $\lambda_1$ and a second signal beam **1918** at wavelength $\lambda_2$. Photoelectric detectors 1985 and **1986** measure the time-varying intensities of signal beams **1917** and **1918,** respectively, to produce interference, heterodyne signals $s_1$ and $s_2$, respectively. The signals $s_j$ have the form

$$s_j = A_j \cos[\alpha_j(t)] \ , \quad j = 1 \text{ and } 2, \tag{4}$$

where the time-dependent arguments $\alpha_j(t)$ are given by

EP 1 514 074 B1

$$\alpha_j(t) = 2\pi f_j t + \varphi_j \quad , \qquad j = 1 \text{ and } 2, \tag{5}$$

Heterodyne signals $s_1$ and $s_2$ are transmitted to processing system 1909 for analysis as electronic signals 1903 and 1904, respectively, in either digital or analog format. Processing system **1909** also receives electronic signals **1901** and **1902** from drivers **1995** and **1996,** respectively, indicative of their respective driving frequencies (e.g., heterodyne split frequencies $f_1$ and $f_2$) and phases.

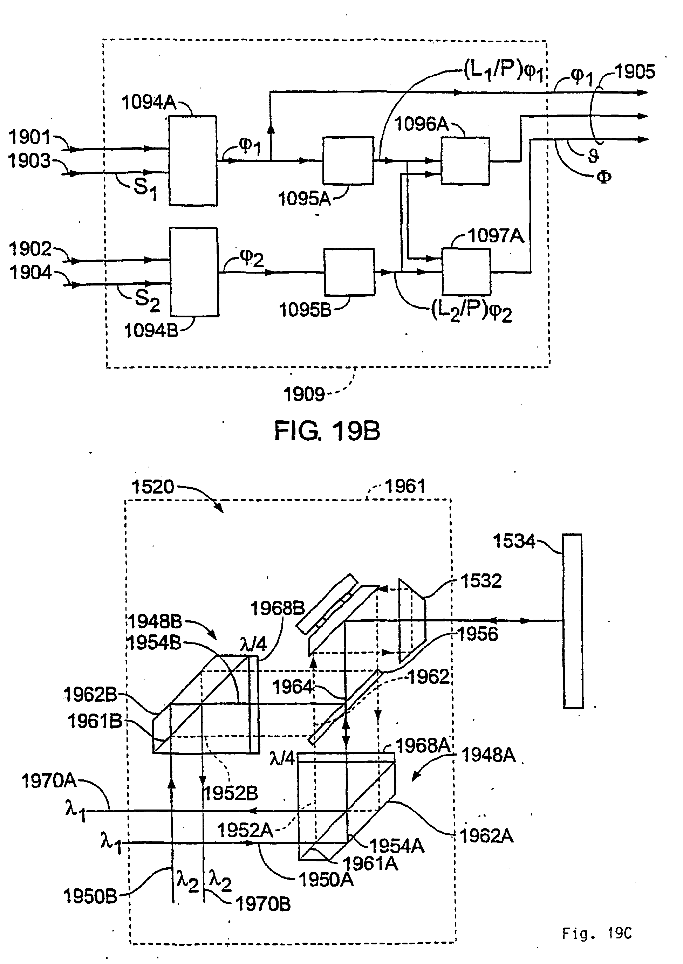

Referring to FIG. **19b,** processing system **1909** further includes electronic processors **1094A** and **1094B** to determine the phases $\varphi_1$ and $\varphi_2$, respectively. Processor **1094A** determines $\varphi_1$ based on signal **1903** ($s$) and signal **1901** (heterodyne reference phase at $f_1$ for driver **1995),** and processor **1094B** determines $\varphi_2$ based on signal **1904** ($s_2$) and signal **1902** (heterodyne reference phase at $f_2$ for driver **1996).** The processors can use either digital or analog signal processing techniques, including, e.g., time-based phase detection such as a digital Hilbert transform phase detector. See, e.g., section 4.1.1 of R.E. Best, "Phase-locked loops: theory, design, and applications" 2nd ed. (McGraw-Hill, New York, 1993). Signals **1901** and **1902** can be derived from mixed reference phase beams produced by mixing the polarization components of a portion of each of beams **1999** and **1990,** respectively.

Phases $\varphi_1$ and $\varphi_2$ determined by processors **1094A** and **1094B** are next multiplied by $l_1/p$ and $l_2/p$, respectively, in electronic processors **1095A** and **1095B,** respectively, preferably by digital processing, resulting in phases $(l_1/p)\varphi_1$ and $(l_2/p)\varphi_2$, respectively. The phases $(l_1/p)\varphi_1$ and $(l_2/p)\varphi_2$ are next added together in electronic processor **1096A** and subtracted one from the other in electronic processor **1097A,** preferably by digital processes, to create the phases $\vartheta$ and $\Phi$, respectively. Formally,

$$\vartheta = \left( \frac{l_1}{p}\varphi_1 + \frac{l_2}{p}\varphi_2 \right) \quad , \tag{6}$$

$$\Phi = \left( \frac{l_1}{p}\varphi_1 - \frac{l_2}{p}\varphi_2 \right) \quad . \tag{7}$$

Referring again to FIG. **19a,** the phases $\varphi_1$, $\vartheta$, and $\Phi$ are transmitted to computer **1910** as signal **1905,** in either digital or analog format.

The refractivity of the gas in the measurement path to the measurement object, $(n_1-1)$, can be calculated using the formula

$$n_1 - 1 = \frac{\Gamma}{\chi L\left[1-\left(K/\chi\right)^2\right]}\left\{\left[\vartheta\left(K/\chi\right)-\Phi\right]-Q\right\} \quad , \tag{8}$$

where

$$\chi = \left(l_1 k_1 + l_2 k_2\right)/2 \quad , \tag{9}$$

$$K = \left(l_1 k_1 - l_2 k_2\right)/2 \quad , \tag{10}$$

12

$$\Gamma = \frac{n_1 - 1}{n_2 - n_1} \quad , \tag{11}$$

the quantity $\Gamma$ being the reciprocal dispersive power of the gas which is substantially independent of environmental conditions and turbulence in the gas. The offset term $Q$ is defined as

$$Q = \xi(K/\chi) - Z \quad , \tag{12}$$

where

$$\xi = \left( \frac{l_1}{p} \zeta_1 + \frac{l_2}{p} \zeta_2 \right) \quad , \tag{13}$$

$$Z = \left( \frac{l_1}{p} \zeta_1 - \frac{l_2}{p} \zeta_2 \right) \quad . \tag{14}$$

Values of $\Gamma$ may be computed from knowledge of the gas composition and from knowledge of the wavelength dependent refractivities of the gas constituents. For example, for the wavelengths $\lambda_1$ equal to 632.8 nm and $\lambda_2$ equal to 316.4 nm, $\Gamma$ equals about 21.4.

For those applications related to displacement measuring interferometry, the heterodyne phase $\varphi_1$ and phases $\vartheta$ and $\Phi$ may be used to determine the geometric distance L , independent of the effects of the refractive index of gas 1998 in the measurement path, using the formula:

$$L = \frac{1}{(\chi + K)} \left\{ \frac{l_1}{p} (\varphi_1 - \zeta_1) - \frac{\Gamma}{[1 - (K/\chi)]} [(K/\chi)\vartheta - \Phi - Q] \right\} \quad . \tag{15}$$

The ratio of the wavelengths can be expressed in terms of ($K/\chi$) from Eqs. (9) and (10) with the result

$$\frac{\lambda_1}{\lambda_2} = \left( \frac{l_1}{l_2} \right) \left[ \frac{1 - (K/\chi)}{1 + (K/\chi)} \right] \quad . \tag{16}$$

When operating under the condition

$$|K/\chi| \ll \frac{(n_2 - n_1)}{(n_2 + n_1)} \quad , \tag{17}$$

the ratio of the phases $\Phi$ and $\vartheta$ has the approximate value

$$(\Phi/\vartheta) \cong -\frac{(n_2 - n_1)}{(n_2 + n_1)} \qquad . \qquad (18)$$

Where $\varepsilon$ is the relative precision desired for the measurement of the refractivity of the gas or of the change in the optical path length of the measurement leg due to the gas, and the following inequality applies:

$$\left| \frac{\lambda_1}{\lambda_2} - \frac{l_1}{l_2} \right| \ll \left( \frac{l_1}{l_2} \right)(n_2 - n_1)\varepsilon \qquad , \qquad (19)$$

Eqs. (8) and (15) reduce to more simple forms of

$$\dot{n}_1 - 1 = -\frac{\Gamma}{\chi L}(\Phi + Q) \qquad , \qquad (20)$$

$$L = \frac{1}{\chi}\left[ \frac{l_1}{p}(\varphi_1 - \zeta_1) + \Gamma(\Phi + Q) \right] \qquad , \qquad (21)$$

respectively. Using the equations above, computer 1910 calculates ($n_1$ - 1), L , and/or changes in L based on signal 1905 from processing system 1909. Similar calculations for L can also be performed with respect to $n_2$.

In the presently described example, interferometer unit 1960 receives input beam 1920 and produces exit beam 1915, each of which include both wavelengths $\lambda_1$ and $\lambda_2$. In other examples, the interferometer unit can include polarizer 1944 and dichroic beam splitter 1980 to directly produce signal beams 1917 and 1918. Also, rather than mixing polarizations of exit beam 1915 when it includes both wavelengths $\lambda_1$ and $\lambda_2$, the interferometer unit can split beam 1915 into beams having either wavelength $\lambda_1$ or wavelength $\lambda_2$, and then mix the polarizations of each of the split beams to produce signal beams **1917** and **1918.** Furthermore, in other examples, the interferometer unit can include dichroic beam splitter **1914** to combine two input beams at wavelengths $\lambda_1$ and $\lambda_2$, respectively, into one input beam at both wavelengths. Also, the interferometer unit can receive separate input beams at wavelengths $\lambda_1$ and $\lambda_2$, respectively, and include one or more dichroic beam splitters to separate each of the input beams into reference and measurement beams at their respective wavelengths. In the latter case, the interferometer unit directs the measurement beams at wavelengths $\lambda_1$ and $\lambda_2$ along a common path contacting the measurement object, and then recombine each of the measurement beams with its respective reference beam.

FIG. **19c** schematically illustrates such an interferometer unit **1961.** Polarizing beam splitter **1948a** separates input beam **1950a** at wavelength $\lambda_1$ into reference beam **1952a** and measurement beam **1954a,** both at wavelength $\lambda_1$. Similarly, polarizing beam splitter **1948b** separates input beam **1950b** at wavelength $\lambda_2$ into reference beam **1952b** and measurement beam **1954b,** both at wavelength $\lambda_2$. For example, input beams **1950a** and **1950b** can be beams **1990** and **1999,** respectively, from FIG. **19a.** Polarizing beam splitters **1948a** and **1948b** have polarizing beam splitting surfaces **1961a** and **1961b,** respectively, and reflective surfaces **1962a** and **1962b,** respectively. Dichroic beam splitter **1956** combines reference beams **1952a** and **1952b** into reference beam **1962** having both wavelengths $\lambda_1$ and $\lambda_2$, and combines measurement beams **1954a** and **1954b** into measurement beam **1964** having both wavelengths $\lambda_1$ and $\lambda_2$. Reference beams **1952a, 1952b,** and **1962** are depicted as dashed lines in FIG. **19c,** whereas measurement beams **1954a, 1954b,** and **1964** are depicted as solid lines in FIG. **19c.**

Reference beam **1962** and measurement beam **1964** propagate to beam steering assembly **1520,** which directs reference beam to retroreflector **1532** and measurement beam to stage mirror **1534.** Retroreflector **1532** and stage mirror **1534** reflect the reference and measurement beam, respectively, back to beam steering assembly **1520,** which redirects the beams back to dichroic beam splitter **1956.** Dichroic beam splitter **1956** then separates reference beam **1962** back into reference beams **1952a** and **1952b** having wavelengths $\lambda_1$ and $\lambda_2$, respectively, and separates reference

**EP 1 514 074 B1**

beam **1964** back into measurement beams **1954a** and **1954b** having wavelengths $\lambda_1$ and $\lambda_2$, respectively. Reference and measurement beams **1952a** and **1954a** then propagate to polarizing beam splitter **1948a,** where because they doubled pass quarter wave plate **1968a,** polarizing beam splitter **1948a** recombines them to form exit beam **1970a** having wavelength $\lambda_1$. Similarly, reference and measurement beams **1952b** and **1954b** then propagate to polarizing beam splitter **1948b,** where because they doubled pass quarter wave plate **1968b,** polarizing beam splitter **1948b** recombines them to form exit beam **1970b** having wavelength $\lambda_2$. A portion of one of exit beams **1970a** and **1970b** is sent to a detector system (not shown) such as detector system **1544** to generate a control signal that causes beam steering assembly **1512** to redirect reference and measurement beams **1962** and **1964** in response to changes in the angular orientation of stage mirror **1534**. The description of such a control system is identical that described previously with reference to the embodiment of FIG. **15a.**

Exit beams **1970a** and **1970b** are indicative of changes in optical path length to stage mirror **1534** at wavelengths $\lambda_1$ and $\lambda_2$, respectively, from which dispersion along the measurement path to the stage mirror can be determined. In particular, a polarizer can be used to mix the reference and measurement beam components of each of the exit beams to produce signal beams **1917** and **1918,** described above with reference to FIG. **19a.**

The interferometry systems described above can be especially useful in lithography applications that fabricate large-scale integrated circuits such as computer chips and the like. Lithography is the key technology driver for the semiconductor manufacturing industry. Overlay improvement is one of the five most difficult challenges down to and below 100 nm line widths (design rules), see for example the *Semiconductor Industry Roadmap,* p82 (1997). Overlay depends directly on the performance, *i.e.* accuracy and precision, of the distance measuring interferometers used to position the wafer and reticle (or mask) stages. Since a lithography tool may produce $50-100M/year of product, the economic value from improved performance distance measuring interferometers is substantial. Each 1% increase in yield of the lithography tool results in approximately $1M/year economic benefit to the integrated circuit manufacturer and substantial competitive advantage to the lithography tool vendor.

The function of a lithography tool is to direct spatially patterned radiation onto a photoresist-coated wafer. The process involves determining which location of the wafer is to receive the radiation (alignment) and applying the radiation to the photoresist at that location (exposure).

To properly position the wafer, the wafer includes alignment marks on the wafer that can be measured by dedicated sensors. The measured positions of the alignment marks define the location of the wafer within the tool. This information, along with a specification of the desired patterning of the wafer surface, guides the alignment of the wafer relative to the spatially patterned radiation. Based on such information, a translatable stage supporting the photoresist-coated wafer moves the wafer such that the radiation will expose the correct location of the wafer.

During exposure, a radiation source illuminates a patterned reticle, which scatters the radiation to produce the spatially patterned radiation. The reticle is also referred to as a mask, and these terms are used interchangeably below. In the case of reduction lithography, a reduction lens collects the scattered radiation and forms a reduced image of the reticle pattern. Alternatively, in the case of proximity printing, the scattered radiation propagates a small distance (typically on the order of microns) before contacting the wafer to produce a 1:1 image of the reticle pattern. The radiation initiates photo-chemical processes in the resist that convert the radiation pattern into a latent image within the resist.

The interferometry systems described above are important components of the positioning mechanisms that control the position of the wafer and reticle, and register the reticle image on the wafer.

In general, the lithography system, also referred to as an exposure system, typically includes an illumination system and a wafer positioning system. The illumination system includes a radiation source for providing radiation such as ultraviolet, visible, x-ray, electron, or ion radiation, and a reticle or mask for imparting the pattern to the radiation, thereby generating the spatially patterned radiation. In addition, for the case of reduction lithography, the illumination system can include a lens assembly for imaging the spatially patterned radiation onto the wafer. The imaged radiation exposes resist coated onto the wafer. The illumination system also includes a mask stage for supporting the mask and a positioning system for adjusting the position of the mask stage relative to the radiation directed through the mask. The wafer positioning system includes a wafer stage for supporting the wafer and a positioning system for adjusting the position of the wafer stage relative to the imaged radiation. Fabrication of integrated circuits can include multiple exposing steps. For a general reference on lithography, see, for example, J. R. Sheats and B. W. Smith, in Microlithography: Science and Technology (Marcel Dekker, Inc., New York, 1998).

The interferometry systems described above can be used to precisely measure the positions of each of the wafer stage and mask stage relative to other components of the exposure system, such as the lens assembly, radiation source, or support structure. In such cases, the interferometry system can be attached to a stationary structure and the measurement object attached to a movable element such as one of the mask and wafer stages. Alternatively, the situation can be reversed, with the interferometry system attached to a movable object and the measurement object attached to a stationary object.

More generally, the interferometry systems can be used to measure the position of any one component of the exposure system relative to any other component of the exposure system, in which the interferometry system is attached to, or supported by, one of the components and the measurement object is attached, or is supported by the other of the components.

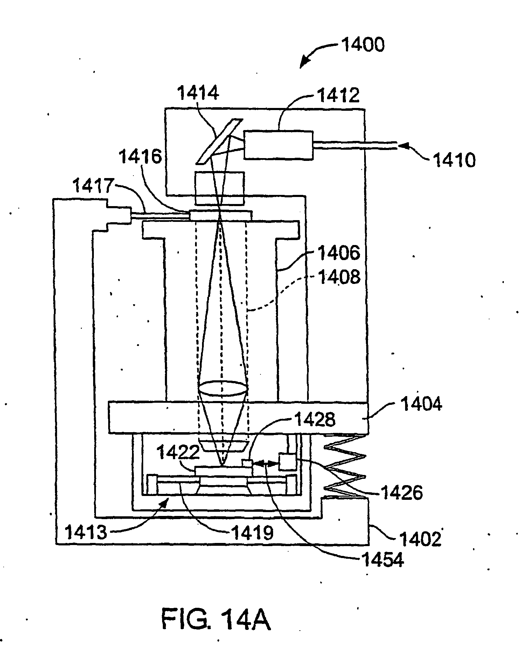

An example of a lithography scanner **1400** using an interferometry system **1426** is shown in Fig. **14a.** The interferometry system is used to precisely measure the position of a wafer within an exposure system. Here, stage **1422** is used to position the wafer relative to an exposure station. Scanner **1400** comprises a frame **1402,** which carries other support structures and various components carried on those structures. An exposure base **1404** has mounted on top of it a lens housing **1406** atop of which is mounted a reticle or mask stage **1416,** which is used to support a reticle or mask. A positioning system for positioning the mask relative to the exposure station is indicated schematically by element **1417.** Positioning system **1417** can include, e.g., piezoelectric transducer elements and corresponding control electronics. Although, it is not included in this described embodiment, one or more of the interferometry systems described above can also be used to precisely measure the position of the mask stage as well as other moveable elements whose position must be accurately monitored in processes for fabricating lithographic structures (see *supra* Sheats and Smith *Microlithography: Science and Technology*).

Suspended below exposure base **1404** is a support base **1413** that carries wafer stage **1422.** Stage **1422** includes a plane mirror **1428** for reflecting a measurement beam **1454** directed to the stage by interferometry system **1426.** A positioning system for positioning stage **1422** relative to interferometry system **1426** is indicated schematically by element **1419.** Positioning system **1419** can include, *e.g.,* piezoelectric transducer elements and corresponding control electronics. The measurement beam reflects back to the interferometry system, which is mounted on exposure base **1404.** The interferometry system can be any of the embodiments described previously.

During operation, a radiation beam **1410,** *e.g.,* an ultraviolet (UV) beam from a UV laser (not shown), passes through a beam shaping optics assembly **1412** and travels downward after reflecting from mirror **1414.** Thereafter, the radiation beam passes through a mask (not shown) carried by mask stage **1416.** The mask (not shown) is imaged onto a wafer (not shown) on wafer stage **1422** via a lens assembly **1408** carried in a lens housing **1406.** Base **1404** and the various components supported by it are isolated from environmental vibrations by a damping system depicted by spring **1420.**

In other embodiments of the lithographic scanner, one or more of the interferometry systems described previously can be used to measure distance along multiple axes and angles associated for example with, but not limited to, the wafer and reticle (or mask) stages. Also, rather than a UV laser beam, other beams can be used to expose the wafer including, *e.g.,* x-ray beams, electron beams, ion beams, and visible optical beams.

In addition, the lithographic scanner can include a column reference in which interferometry system **1426** directs the reference beam to lens housing **1406** or some other structure that directs the radiation beam rather than a reference path internal to the interferometry system. The interference signal produce by interferometry system **1426** when combining measurement beam **1454** reflected from stage **1422** and the reference beam reflected from lens housing **1406** indicates changes in the position of the stage relative to the radiation beam. Furthermore, in other embodiments the interferometry system **1426** can be positioned to measure changes in the position of reticle (or mask) stage **1416** or other movable components of the scanner system. Also, in other embodiments, the positions of interferometry system **1426** and plane mirror **1428** can be reversed, with the interferometry system on the movable stage and the plane mirror fixed to support structure. Finally, the interferometry systems can be used in a similar fashion with lithography systems involving steppers, in addition to, or rather than, scanners.

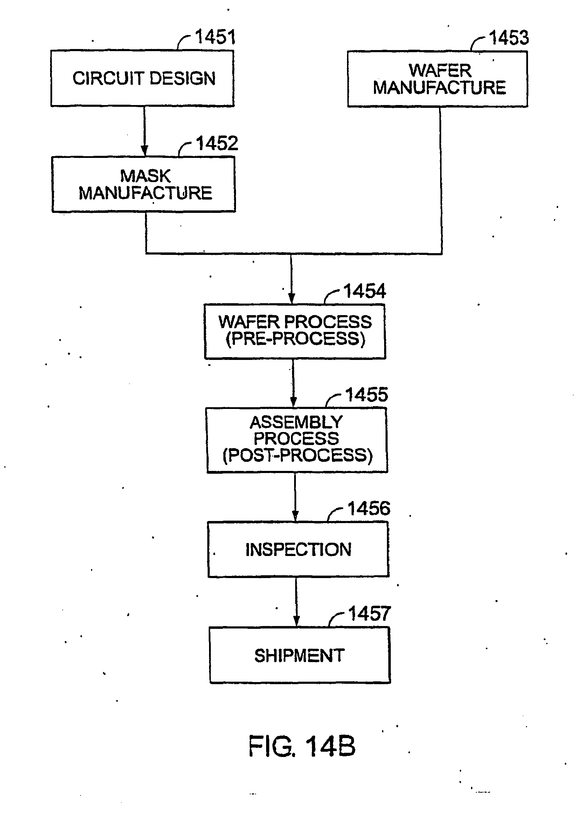

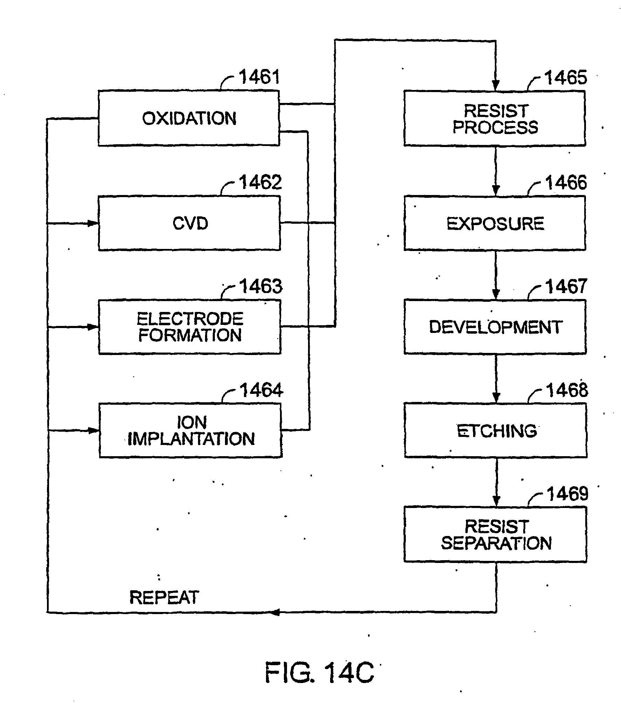

As is well known in the art, lithography is a critical part of manufacturing methods for making semiconducting devices. For example, U.S. Patent 5,483,343 outlines steps for such manufacturing methods. These steps are described below with reference to FIGS. **14b** and **14c.** FIG. **14b** is a flow chart of the sequence of manufacturing a semiconductor device such as a semiconductor chip (*e.g.* IC or LSI), a liquid crystal panel or a CCD. Step **1451** is a design process for designing the circuit of a semiconductor device. Step **1452** is a process for manufacturing a mask on the basis of the circuit pattern design. Step **1453** is a process for manufacturing a wafer by using a material such as silicon.

Step **1454** is a wafer process which is called a pre-process wherein, by using the so prepared mask and wafer, circuits are formed on the wafer through lithography. Step **1455** is an assembling step, which is called a post-process wherein the wafer processed by step **1454** is formed into semiconductor chips. This step includes assembling (dicing and bonding) and packaging (chip sealing). Step 1456 is an inspection step wherein operability check, durability check and so on of the semiconductor devices produced by step **1455** are carried out. With these processes, semiconductor devices are finished and they are shipped (step **1457).**

FIG. 14c is a flow chart showing details of the wafer process. Step **1461** is an oxidation process for oxidizing the surface of a wafer. Step **1462** is a CVD process for forming an insulating film on the wafer surface. Step **1463** is an electrode forming process for forming electrodes on the wafer by vapor deposition. Step **1464** is an ion implanting process for implanting ions to the wafer. Step **1465** is a resist process for applying a resist (photosensitive material) to the wafer. Step **1466** is an exposure process for printing, by exposure, the circuit pattern of the mask on the wafer through the exposure apparatus described above. Step **1467** is a developing process for developing the exposed wafer. Step **1468** is an etching process for removing portions other than the developed resist image. Step **1469** is a resist separation process for separating the resist material remaining on the wafer after being subjected to the etching process. By repeating these processes, circuit patterns are formed and superimposed on the wafer.

The interferometry systems described above can also be used in other applications in which the relative position of an object needs to be measured precisely. For example, in applications in which a write beam such as a laser, x-ray, ion, or electron beam, marks a pattern onto a substrate as either the substrate or beam moves, the interferometry systems can be used to measure the relative movement between the substrate and write beam.

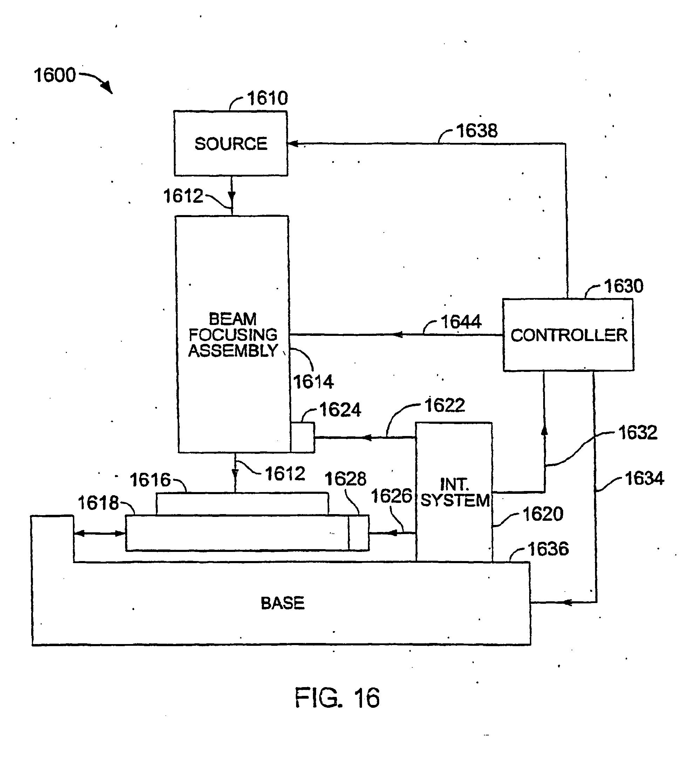

As an example, a schematic of a beam writing system **1600** is shown in FIG. **16.** A source **1610** generates a write beam **1612,** and a beam focusing assembly **1614** directs the radiation beam to a substrate **1616** supported by a movable stage **1618.** To determine the relative position of the stage, an interferometry system **1620** directs a reference beam **1622** to a mirror **1624** mounted on beam focusing assembly **1614** and a measurement beam **1626** to a mirror **1628** mounted on stage **1618.** Interferometry system **1620** can be any of the interferometry systems described previously. Changes in the position measured by the interferometry system correspond to changes in the relative position of write beam **1612** on substrate **1616.** Interferometry system **1620** sends a measurement signal **1632** to controller **1630** that is indicative of the relative position of write beam **1612** on substrate **1616.** Controller **1630** sends an output signal **1634** to a base **1636** that supports and positions stage **1618.** In addition, controller **1630** sends a signal **1638** to source **1610** to vary the intensity of, or block, write beam **1612** so that the write beam contacts the substrate with an intensity sufficient to cause photophysical or photochemical change only at selected positions of the substrate. Furthermore, in some embodiments, controller **1630** can cause beam focusing assembly **1614** to scan the write beam over a region of the substrate, *e.g.,* using signal **1644.** As a result, controller **1630** directs the other components of the system to pattern the substrate. The patterning is typically based on an electronic design pattern stored in the controller. In some applications the write beam patterns a resist coated on the susbstrate and in other applications the write beam directly patterns, e.g., etches, the substrate.

An important application of such a system is the fabrication of masks and reticles used in the lithography methods described previously. For example, to fabricate a lithography mask an electron beam can be used to pattern a chromium-coated glass substrate. In such cases where the write beam is an electron beam, the beam writing system encloses the electron beam path in a vacuum. Also, in cases where the write beam is, e.g., an electron or ion beam, the beam focusing assembly includes electric field generators such as quadrapole lenses for focusing and directing the charged particles onto the substrate under vacuum. In other cases where the write beam is a radiation beam, e.g., x-ray, UV, or visible radiation, the beam focusing assembly includes corresponding optics and for focusing and directing the radiation to the substrate.

It is understood that while the invention has been described in conjunction with the detailed description thereof, the foregoing description is intended to illustrate and not limit the scope of the invention, which is defined by the scope of the appended claims.

For example, although embodiments described above use heterodyne detection to determine changes in the optical path length difference between the reference and measurement paths, the interferometry systems can also use homodyne detection, in which the frequencies of the reference and measurement beams are the same. In such cases, a non-polarizing beam splitter splits the output beam formed by the overlapping exit reference and measurement beams into two components, one of which passes through a quarter wave plate. Thereafter, each of the two components passes through a polarizer to produce a pair of mixed optical signals, which are measured by a pair of detectors, respectively. The electronic signals measured by the detectors are in phase quadrature with one another and can be processed by a computer to determine the changes in the optical path length difference using well-known homodyne processing techniques.

Furthermore, in other embodiments in which the reference beam reflects from a reference object, the interferometry system can include one or more additional beam steering assemblies (and corresponding controllers and detectors) that redirect the reference beam in response to changes in the angular orientation or position of the reference object.

Finally, in other embodiments the beam steering assembly can be different from a mirror oriented by a positioning system. For example, the beam steering assembly can include one or more of the following elements: an electro-optic or acousto-optic beam deflector, a pair of rotating optical wedges (Risely prisms), a variable wedge element, and any other such element that can alter the direction of a light beam.

**Claims**

**1.** Displacement measurement apparatus, comprising:

a multi-axis interferometry system (2306) configured to receive an input beam (2312) and having:

a non-polarizing beam-splitter (2320) adapted to split the input beam into an angle-measuring input beam (2382) and a distance-measuring input beam (2384);

a distance measuring portion (HSPMI) adapted to split the distance-measuring input beam (2384) into a reflected reference beam (2395) and a transmitted measurement beam (2391), and to, following a double pass of the measurement beam (2391) to a measurement object (2380) and a double pass of the reference beam (2395) to the reference object (2338), recombine the reference beam (2395) and the measurement beam (2391) to form a distance-measuring output beam (2374); and

an angle measuring portion adapted to direct angle measurement beams (2393, 2394) derived from the angle-measuring input beam (2382) so as to make single passes to different points in the measurement object (2380) to produce an angle measuring output beam based on optical differencing to reflect changes in an angular orientation of the measurement object (2380);

a beam steering assembly (2314, 2316, 2318) having a beam steering element (2314) positioned to direct the input beam into the multi-axis interferometry system and a positioning system to selectively orient the beam steering element (2314) relative to the multi-axis interferometry system; and

a control circuit (2311) which during operation orients the beam steering element (2314) based on the changes in the angular orientation of the measurement object (2380) monitored by the multi-axis interferometry system (2306); wherein

the multi-axis interferometry system (2306) is adapted to detect the angle measuring output beam (2378) without the angle measuring output beam (2378) contacting the beam steering element (2314).

2. The displacement measurement apparatus of claim 1, wherein the control circuit (2311) is adapted to cause the angle measurement beams (2393, 2394) to contact the measurement object (2380) at substantially normal incidence over a range of angular orientations of the measurement object (2380).

3. The displacement measurement apparatus of claim 1, wherein during operation the control circuit (2311) is adapted to calculate a control signal using an interferometric information in the angle measuring output beam (2378) and adapted to cause the positioning system to orient the beam steering element (2314) based on the control signal.

4. The displacement measurement apparatus of claim 3, wherein the control circuit (2311) comprises a detector (2376) adapted to measure an intensity of the angle measuring output beam (2378), a signal processor adapted to calculate the changes in the angular orientation of the measurement object (2380) from the measured intensity and generating the control signal from the calculated changes in angular orientation, and a control system (2311) adapted to cause the positioning system to orient the beam steering element (2314) in response to the control signal.

5. The displacement measurement apparatus of claim 4, further comprising a polarizer (2375) prior to the detector (2376) to cause the measured intensity of the angle measuring output beam (2378) to correspond to the intensity of a selected polarization component of the angle measuring output beam (2378).

6. The displacement measurement apparatus of claim 1, wherein the changes in the angular orientation of the measurement object (2380) monitored by the multi-axis interferometry system are relative to a reference object.

7. The displacement measurement apparatus of claim 6, wherein the reference object is fixed in the multi-axis interferometry system.

8. A lithography system for use in fabricating integrated circuits on a wafer, the system comprising:

a stage (1422) for supporting the wafer;
an illumination system for imaging spatially patterned radiation onto the wafer;
a positioning system (1417) for adjusting the position of the stage relative to the imaged radiation; and
the displacement measurement apparatus of claim 1 for monitoring the position of the wafer relative to the imaged radiation.

9. The system of claim 8, wherein the measurement object is attached to the stage (1422) and forms part of the system.

10. The system of claim 8, wherein the multi-axis interferometry system is supported by the stage (1422).

11. A lithography system for use in fabricating integrated circuits on a wafer, the system comprising:

a stage (1422) for supporting the wafer; and

an illumination system including a radiation source, a mask, a positioning system, a lens assembly, and the displacement measurement apparatus (2306) of claim 1, wherein during operation the source is adapted to direct radiation through the mask to produce spatially patterned radiation, the positioning system is adapted to adjust the position of the mask relative to the radiation from the source, the lens assembly is adapted to image the spatially patterned radiation onto the wafer, and the apparatus is adapted to monitor the position of the mask relative to the radiation from the source.

12. The system of claim 11, wherein the measurement object is attached to the mask and forms part of the system.

13. The system of claim 11, wherein the multi-axis interferometry system is attached to the mask.

14. A beam writing system for use in fabricating a lithography mask, the system comprising:

a source is adapted to provide a write beam to pattern a substrate;
a stage is adapted to support the substrate;
a beam directing assembly for delivering the write beam to the substrate;
a positioning system for positioning the stage and beam directing assembly relative to one another; and
the displacement measurement apparatus (2306) of claim 1, for monitoring the position of the stage relative to the beam directing assembly.

15. A method for fabricating integrated circuits comprising using the lithography system of claim 11.

16. A method for fabricating a lithography mask comprising using the beam writing system of claim 14.


### Patentansprüche

1. Wegmessvorrichtung, die Folgendes umfasst:

ein Mehrachsen-Interferometriesystem (2306), das konfiguriert ist, einen Eingangsstrahl (2312) zu empfangen, und Folgendes aufweist:

einen nicht polarisierenden Strahlteiler (2320), der ausgelegt ist, den Eingangsstrahl in einen Winkelmesseingangsstrahl (2382) und einen Abstandsmesseingangsstrahl (2384) zu teilen;
einen Abstandsmessabschnitt (HSPMI), der ausgelegt ist, den Abstandsmesseingangsstrahl (2384) in einen reflektierten Referenzstrahl (2395) und einen gesendeten Messstrahl (2391) zu teilen und auf einen Zweifachdurchgang des Messstrahles (2391) zu einem Messobjekt (2380) und einem Zweifachdurchgang des Referenzstrahles (2395) zum Referenzobjekt (2338) folgend den Referenzstrahl (2395) und den Messstrahl (2391) wieder zu kombinieren, um einen Abstandsmessausgangsstrahl (2374) zu bilden; und
einen Winkelmessabschnitt, der ausgelegt ist, Winkelmessstrahlen (2393, 2394), die aus dem Winkelmesseingangsstrahl (2382) hergeleitet worden sind, so zu richten, dass sie Einfachdurchgänge zu unterschiedlichen Punkten im Messobjekt (2380) machen, um basierend auf optischem Differenzieren einen Winkelmessausgangsstrahl zu erzeugen, um Änderungen in einer Winkelausrichtung des Messobjektes (2380) zu reflektieren;
eine Strahllenkbaugruppe (2314, 2316, 2318), die ein Strahllenkelement (2314), das so angeordnet ist, dass es den Eingangsstrahl in das Mehrachsen-Interferometriesystem richtet, und ein Positioniersystem aufweist, um das Strahllenkelement (2314) relativ zum Mehrachsen-Interferometriesystem selektiv auszurichten; und
eine Steuerschaltung (2311), die während des Betriebes das Strahllenkelement (2314) basierend auf den Änderungen in der Winkelausrichtung des Messobjektes (2380) ausrichtet, das durch das Mehrachsen-Interferometriesystem (2306) überwacht wird; wobei
das Mehrachsen-Interferometriesystem (2306) ausgelegt ist, den Winkelmessausgangsstrahl (2378) zu detektieren, ohne dass der Winkelmessausgangsstrahl (2378) das Strahllenkelement (2314) berührt.

2. Wegmessvorrichtung nach Anspruch 1, wobei die Steuerschaltung (2311) ausgelegt ist, zu veranlassen, dass der Winkelmessstrahl (2393, 2394) über einen Bereich von Winkelausrichtungen des Messobjektes (2380) das Messobjekt (2380) unter im Wesentlichen normalem Einfall berührt.

3. Wegmessvorrichtung nach Anspruch 1, wobei während des Betriebes die Steuerschaltung (2311) ausgelegt ist, unter Verwendung von interferometrischen Informationen im Winkelmessausgangsstrahl (2378) ein Steuersignal zu berechnen, und ausgelegt ist, zu veranlassen, dass das Positioniersystem das Strahllenkelement (2314) basierend auf dem Steuersignal ausrichtet.

4. Wegmessvorrichtung nach Anspruch 3, wobei die Steuerschaltung (2311) einen Detektor (2376), der ausgelegt ist, eine Intensität des Winkelmessausgangsstrahles (2378) zu messen, einen Signalprozessor, der ausgelegt ist, aus der gemessenen Intensität die Änderungen in der Winkelausrichtung des Messobjektes (2380) zu berechnen, und aus den berechneten Änderungen in der Winkelausrichtung das Steuersignal erzeugt, und ein Steuersystem (2311) umfasst, das ausgelegt ist, zu veranlassen, dass das Positioniersystem das Strahllenkelement (2314) in Reaktion auf das Steuersignal ausrichtet.

5. Wegmessvorrichtung nach Anspruch 4, die ferner vor dem Detektor (2376) einen Polarisator (2375) umfasst, um zu veranlassen, dass die gemessene Intensität des Winkelmessausgangsstrahles (2378) der Intensität einer ausgewählten Polarisationskomponente des Winkelmessausgangsstrahles (2378) entspricht.

6. Wegmessvorrichtung nach Anspruch 1, wobei die Änderungen in der Winkelausrichtung des Messobjektes (2380), das durch das Mehrachsen-Interferometriesystem überwacht wird, relativ zu einem Referenzobjekt sind.

7. Wegmessvorrichtung nach Anspruch 6, wobei das Referenzobjekt im Mehrachsen-Interferometriesystem fest ist.

8. Lithografiesystem zur Verwendung beim Herstellen integrierter Schaltungen auf einem Wafer, wobei das System Folgendes umfasst:

 eine Plattform (1422) zum Halten des Wafers;
 ein Beleuchtungssystem zum Abbilden räumlich gemusterter Strahlung auf den Wafer;
 ein Positioniersystem (1417) zum Einstellen der Position der Plattform relativ zur abgebildeten Strahlung und die Wegmessvorrichtung nach Anspruch 1 zum Überwachen der Position des Wafers relativ zur abgebildeten Strahlung.

9. System nach Anspruch 8, wobei das Messobjekt an der Plattform (1422) angebracht ist und einen Teil des Systems bildet.

10. System nach Anspruch 8, wobei das Mehrachsen-Interferometriesystem durch die Plattform (1422) gehalten ist.

11. Lithografiesystem zur Verwendung beim Herstellen integrierter Schaltungen auf einem Wafer, wobei das System Folgendes umfasst:

 eine Plattform (1422) zum Halten des Wafers und
 ein Beleuchtungssystem, das eine Strahlungsquelle, eine Maske, ein Positioniersystem, eine Linsenbaugruppe und die Wegmessvorrichtung (2306) nach Anspruch 1 beinhaltet, wobei während des Betriebes die Quelle ausgelegt ist, Strahlung durch die Maske zu richten, um räumlich gemusterte Strahlung zu erzeugen, das Positioniersystem ausgelegt ist, die Position der Maske relativ zur Strahlung aus der Quelle einzustellen, die Linsenbaugruppe ausgelegt ist, die räumlich gemusterte Strahlung auf den Wafer abzubilden, und die Vorrichtung ausgelegt ist, die Position der Maske relativ zur Strahlung aus der Quelle zu überwachen.

12. System nach Anspruch 11, wobei das Messobjekt an der Maske angebracht ist und einen Teil des Systems bildet.

13. System nach Anspruch 11, wobei das Mehrachsen-Interferometriesystem an der Maske angebracht ist.

14. Strahlschreibsystem zur Verwendung beim Herstellen einer Lithografiemaske, wobei das System Folgendes umfasst:

 eine Quelle, die ausgelegt ist, einen Schreibstrahl bereitzustellen, um ein Substrat zu mustern;
 eine Plattform, die ausgelegt ist, das Substrat zu halten;
 eine Strahlrichtbaugruppe zum Zuführen des Schreibstrahles zum Substrat;
 ein Positioniersystem zum Positionieren der Plattform und Strahlrichtbaugruppe relativ zueinander und die Wegmessvorrichtung (2306) nach Anspruch 1 zum Überwachen der Position der Plattform relativ zur Strahlrichtbaugruppe.

**15.** Verfahren zum Herstellen integrierter Schaltungen, das Verwenden des Lithografiesystems nach Anspruch 11 umfasst.

**16.** Verfahren zum Herstellen einer Lithografiemaske, das Verwenden des Strahlschreibsystems nach Anspruch 14 umfasst.

**Revendications**

**1.** Appareil de mesure de déplacement, comprenant :

un système d'interférométrie à multiples axes (2306) configuré pour recevoir un faisceau d'entrée (2312) et ayant :

un séparateur de faisceau non polarisant (2320) conçu pour diviser le faisceau d'entrée en un faisceau d'entrée de mesure d'angle (2382) et un faisceau d'entrée de mesure de distance (2384) ;
une portion de mesure de distance (HSPMI) conçue pour diviser le faisceau d'entrée de mesure de distance (2384) en un faisceau de référence réfléchi (2395) et en un faisceau de mesure transmis (2391), et pour, après un double passage du faisceau de mesure (2391) sur un objet de mesure (2380) et un double passage du faisceau de référence (2395) sur l'objet de référence (2338), recombiner le faisceau de référence (2395) et le faisceau de mesure (2391) pour former un faisceau de sortie de mesure de distance (2374) ; et
une portion de mesure d'angle conçue pour diriger des faisceaux de mesure d'angle (2393, 2394) dérivés à partir du faisceau d'entrée de mesure d'angle (2382) afin d'effectuer des passages uniques sur des points différents dans l'objet de mesure (2380) pour produire un faisceau de sortie de mesure d'angle sur base de calculs de différence optique pour refléter des changements d'une orientation angulaire de l'objet de mesure (2380) ;
un ensemble de guidage de faisceau (2314, 2316, 2318) ayant un élément de guidage de faisceau (2314) positionné pour diriger le faisceau d'entrée dans le système d'interférométrie à multiples axes et un système de positionnement pour orienter sélectivement l'élément de guidage de faisceau (2314) par rapport au système d'interférométrie à multiples axes ; et
un circuit de commande (2311) qui pendant l'opération oriente l'élément de guidage de faisceau (2314) sur base des changements de l'orientation angulaire de l'objet de mesure (2380) contrôlée par le système d'interférométrie à multiples axes (2306) ; dans lequel
le système d'interférométrie à multiples axes (2306) est conçu pour détecter le faisceau de sortie de mesure d'angle (2378) sans que le faisceau de sortie de mesure d'angle (2378) n'entre en contact avec l'élément de guidage de faisceau (2314).

**2.** Appareil de mesure de déplacement selon la revendication 1, dans lequel le circuit de commande (2311) est conçu pour amener les faisceaux de mesure d'angle (2393, 2394) à entrer en contact avec l'objet de mesure (2380) à une incidence substantiellement normale sur une plage d'orientations angulaires de l'objet de mesure (2380).

**3.** Appareil de mesure de déplacement selon la revendication 1, dans lequel, pendant l'opération, le circuit de commande (2311) est conçu pour calculer un signal de commande en utilisant une information interférométrique dans le faisceau de sortie de mesure d'angle (2378) et conçu pour amener le système de positionnement à orienter l'élément de guidage de faisceau (2314) sur base du signal de commande.

**4.** Appareil de mesure de déplacement selon la revendication 3, dans lequel le circuit de commande (2311) comprend un détecteur (2376) conçu pour mesurer une intensité du faisceau de sortie de mesure d'angle (2378), un processeur de signal conçu pour calculer les changements de l'orientation angulaire de l'objet de mesure (2380) à partir de l'intensité mesurée et générant le signal de commande à partir des changements calculés de l'orientation angulaire, et un système de commande (2311) conçu pour amener le système de positionnement à orienter l'élément de guidage de faisceau (2314) en réponse au signal de commande.

**5.** Appareil de mesure de déplacement selon la revendication 4, comprenant en outre un polariseur (2375) avant le détecteur (2376) pour amener l'intensité mesurée du faisceau de sortie de mesure d'angle (2378) à correspondre à l'intensité d'un composant de polarisation sélectionné du faisceau de sortie de mesure d'angle (2378).

**6.** Appareil de mesure de déplacement selon la revendication 1, dans lequel les changements de l'orientation angulaire de l'objet de mesure (2380) contrôlée par le système d'interférométrie à multiples axes sont relatifs à un objet de référence.

**7.** Appareil de mesure de déplacement selon la revendication 6, dans lequel l'objet de référence est fixé dans le système d'interférométrie à multiples axes.

**8.** Système de lithographie pour utilisation dans la fabrication de circuits intégrés sur une plaquette, le système comprenant :

une platine (1422) pour supporter la plaquette ;
un système d'éclairage pour de l'imagerie de rayonnement à motifs dans l'espace sur la plaquette ;
un système de positionnement (1417) pour ajuster la position de la platine par rapport au rayonnement imagé ; et
l'appareil de mesure de déplacement selon la revendication 1 pour contrôler la position de la plaquette par rapport au rayonnement imagé.

**9.** Système selon la revendication 8, dans lequel l'objet de mesure est attaché à la platine (1422) et forme une partie du système.

**10.** Système selon la revendication 8, dans lequel le système d'interférométrie à multiples axes est supporté par la platine (1422).

**11.** Système de lithographie pour utilisation dans la fabrication de circuits intégrés sur une plaquette, le système comprenant :

une platine (1422) pour supporter la plaquette ; et
un système d'éclairage incluant une source de rayonnement, un masque, un système de positionnement, un ensemble lentille, et l'appareil de mesure de déplacement (2306) de la revendication 1, dans lequel, pendant l'opération, la source est conçue pour diriger du rayonnement à travers le masque pour produire du rayonnement à motifs dans l'espace, le système de positionnement est conçu pour ajuster la position du masque par rapport au rayonnement en provenance de la source, l'ensemble lentille est conçu pour effectuer de l'imagerie du rayonnement à motifs dans l'espace sur la plaquette, et l'appareil est conçu pour contrôler la position du masque par rapport au rayonnement en provenance de la source.

**12.** Système selon la revendication 11, dans lequel l'objet de mesure est attaché au masque et forme une partie du système.

**13.** Système selon la revendication 11, dans lequel le système d'interférométrie à multiples axes est attaché au masque.

**14.** Système d'écriture de faisceau pour utilisation dans la fabrication d'un masque de lithographie, le système comprenant :

une source conçue pour fournir un faisceau d'écriture pour donner un motif à un substrat ;
une platine conçue pour supporter le substrat ;
un ensemble de direction de faisceau pour délivrer le faisceau d'écriture au substrat ;
un système de positionnement pour positionner la platine et l'ensemble de direction de faisceau l'un par rapport à l'autre ; et
l'appareil de mesure de déplacement (2306) de la revendication 1, pour contrôler la position de la platine par rapport à l'ensemble de direction de faisceau.

**15.** Procédé de fabrication de circuits intégrés comprenant l'utilisation du système de lithographie selon la revendication 11.

**16.** Procédé de fabrication d'un masque de lithographie comprenant l'utilisation du système d'écriture de faisceau selon la revendication 14.

FIG. 14A

FIG. 14B

1461
OXIDATION

1462
CVD

1463
ELECTRODE
FORMATION

1464
ION
IMPLANTATION

1465
RESIST
PROCESS

1466
EXPOSURE

1467
DEVELOPMENT

1468
ETCHING

1469
RESIST
SEPARATION

REPEAT

FIG. 14C

FIG. 15A

EP 1 514 074 B1

FIG. 15B

FIG. 15C

FIG. 15D

EP 1 514 074 B1

FIG. 16

FIG. 17A

EP 1 514 074 B1

1716B — 1732 — 1716A
1718B — — 1718A
— 1534
— 1536
— 1512
1740D — 1740A
1713 — 1514

**FIG. 17B**

1715B — 1715A
1717B — 1717A
1713 — 1514

**FIG. 17C**

Fig. 19A

EP 1 514 074 B1

FIG. 19B

Fig. 19C

FIG. 21

EP 1 514 074 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6313918 B1
- US 5801832 A
- US 35170803 A
- US 30580899 A

- US 4684828 A, G.E. Sommargren
- US 4687958 A
- US 06192898 A, H.A. Hill
- US 5483343 A

**Non-patent literature cited in the description**

- **N. BOBROFF.** *Appl. Opt.,* 1986, vol. 26, 2676-2681
- **R.E. BEST.** Phase-locked loops: theory, design, and applications. McGraw-Hill, 1993

- **J. R. SHEATS ; B. W. SMITH.** Microlithography: Science and Technology. Marcel Dekker, Inc, 1998